# EUROPEAN PATENT APPLICATION

(11) **EP 2 246 900 A1**
(43) Date of publication of application: **03.11.2010**
(21) Application number: 09705223.7
(22) Date of filing: 20.01.2009
(51) Int. Cl.: H01L 31/042

(54) **SOLAR BATTERY, LIGHT COLLECTION TYPE SOLAR POWER GENERATING MODULE AND SOLAR BATTERY MANUFACTURING METHOD**

(30) Priority: 01.02.2008 JP 2008023021; 09.05.2008 JP 2008123938
(71) Applicant: Sharp Kabushiki Kaisha, Osaka-shi, Osaka 545-8522 (JP)
(72) Inventor: OKAMOTO, Chikao, Osaka-shi, Osaka 545-8522 (JP)
(74) Representative: Müller - Hoffmann & Partner
(86) International application number: PCT/JP2009/050762
(87) International publication number: WO 2009/096267

(57) **Abstract**

A solar cell 210 includes a columnar optical member 230 having an incidence surface 231 on which sunlight Ls is incident and an irradiation surface 232 that is disposed facing the solar cell element 211 and that irradiates the sunlight Ls to the solar cell element 211; and a holding portion 240 that holds the columnar optical member 230. The holding portion 240 includes an abutting frame member 241 that is abutted against a side surface 233 of the columnar optical member 230 and that is configured to have a thickness t in a direction from the incidence surface 231 to the irradiation surface 232 and a support 242 that is disposed away from the columnar optical member 230 and that supports the abutting frame member 241. The side surface 233 of the columnar optical member 230 is inclined such that the sunlight Ls is totally reflected in a direction of the irradiation surface 232, and the incidence surface 231 of the columnar optical member 230 is configured of a size such that an incidence surface concentrated light beam region FLRd is locatable inside the incidence surface 231.

## Description

### Technical Field

The present invention relates to a solar cell including a solar cell element that photoelectrically converts concentrated sunlight and a columnar optical member that irradiates the concentrated sunlight to the solar cell element, a concentrating solar power generation module that includes such a solar cell, and a solar cell manufacturing method for manufacturing such a solar cell.

### Background Art

A non-concentrating, fixed flat plate structure in which a solar power generation module in which solar cell elements are laid without a gap therebetween is installed on the roof or the like is most commonly used for solar power generation apparatuses. For such solar power generation apparatuses, a technique has been proposed to reduce the number of solar cell elements used, these being one of the expensive members (components) constituting a solar power generation apparatus.

That is, it has been proposed to concentrate sunlight by using an optical lens, reflecting mirror or the like and irradiate the concentrated sunlight to a solar cell element with a small area so as to increase the power generation per unit area of the solar cell element, as well as reducing the cost of solar cell elements (in other words, the cost of a solar power generation apparatus).

Generally speaking, the photoelectric conversion efficiency of a solar cell element is improved as the concentration magnification is increased. However, if the position of the solar cell element remains fixed, most sunlight is incident obliquely, failing to make efficient use of the sunlight. In view of this, a sun-tracking concentrating solar power generation apparatus has been proposed that has a high concentration magnification and is configured to track the sun so as to always receive sunlight at the front (see, for example, Patent Documents 1 to 5).

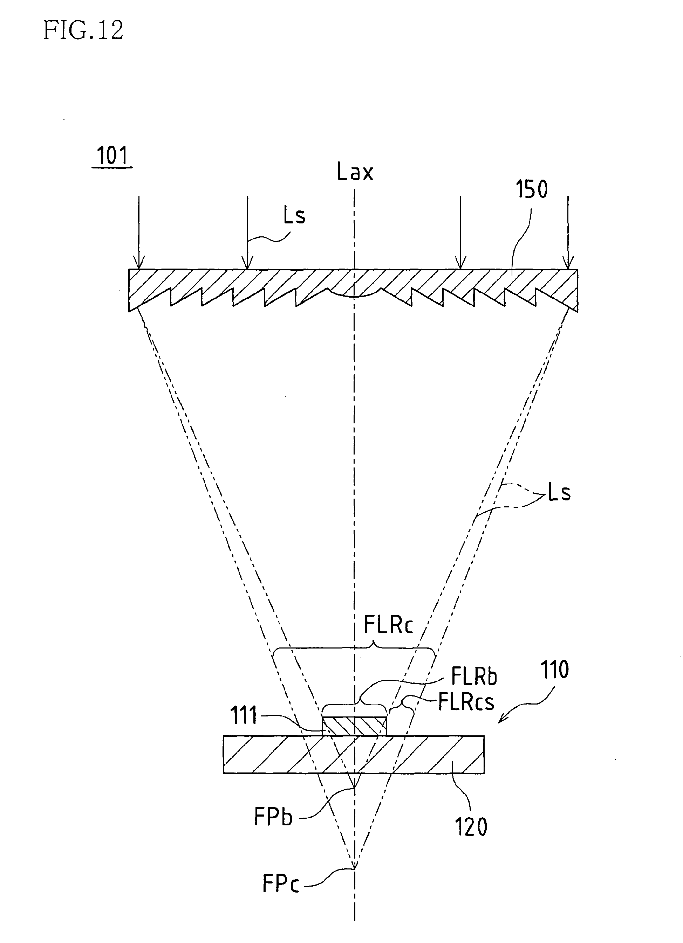

FIG. 12 is a cross-sectional view showing an example of a configuration of a concentrating solar power generation module that is applied to a sun-tracking concentrating solar power generation apparatus of Conventional Example 1.

A concentrating solar power generation module 101 according to Conventional Example 1 includes a concentrating lens 150 that receives and concentrates sunlight Ls that is perpendicularly incident on the incidence surface in parallel with the optical axis Lax and a solar cell 110 that photoelectrically converts the sunlight Ls that is concentrated by the concentrating lens 150. The solar cell 110 includes a solar cell element 111 that photoelectrically converts the concentrated sunlight Ls and a receiver substrate 120 on which the solar cell element 111 is placed.

The wavelength range of the sunlight Ls includes a medium- and short-wavelength side region ranging from a short wavelength of 400 nm to a medium wavelength of 1000 nm (1 µm) and a long-wavelength side region of greater than 1 µm. Accordingly, of the sunlight Ls concentrated by the concentrating lens 150, the sunlight Ls in the medium- and short-wavelength side region is concentrated toward the focal point FPb side, and is concentrated to the vicinity of the center of the solar cell element 111, thus constituting a medium- and short-wavelength side concentrated light beam region FLRb. On the other hand, the sunlight Ls in the long-wavelength side region is concentrated toward the focal point FPc side, thus constituting a long-wavelength side concentrated light beam region FLRc in the medium- and short-wavelength side concentrated light beam region FLRb and the outer periphery thereof (for example, on the outer periphery of the solar cell element 111).

The sun-tracking concentrating solar power generation apparatus of Conventional Example 1 employs the concentrating solar power generation module 101, which can provide a high concentration magnification through the action of the concentrating lens 150.

However, because the refraction by the concentrating lens 150 is slightly different for each of a wide variety of wavelengths of sunlight Ls, the refractive state significantly differs depending on the wavelength range. Accordingly, the sunlight Ls (an outer peripheral side region FLRcs of the long-wavelength side concentrated light beam region FLRc) that is not concentrated to the solar cell element 111 may be generated, as described above.

In addition, because positional shift or the like occurs due to an alignment error between the concentrating lens 150 and the solar cell element 111 or the difference in temperature characteristics between the members that constitute the solar power generation module 101, positional shift occurs with respect to the center (optical axis Lax) of the solar cell element 111, as is the case where the refractive state differs. In other words, positional shift of the sunlight Ls that is to be irradiated to the solar cell element 111 occurs, as a result of which the light-concentrating efficiency may fluctuate and thus be reduced.

Accordingly, the generation of the sunlight Ls that is not aligned with the solar cell element 111 due to the difference in the refractive state depending on the wavelength range and the positional shift between constituent members will pose a problem in that the substantial amount of light incident on the solar cell element 111 decreases, reducing the photoelectric conversion efficiency and the power generation (output) of the solar cell 110 (the solar cell element 111), and also causing an undesired loss.

In addition, when the sunlight Ls that has been undergone positional shift is irradiated to a region other than the solar cell element 111, a problem arises in that the temperature of the members (for example, an insulating film, wiring, and so forth, provided on the receiver substrate 120) irradiated with the displaced sunlight Ls increases due to the thermal energy of the displaced sunlight Ls, and the members may be fire damaged (damaged) in some cases.

The solar cell element 111 has another problem in that it generates heat due to the concentrated sunlight Ls and the power generation (output) is reduced as a result.

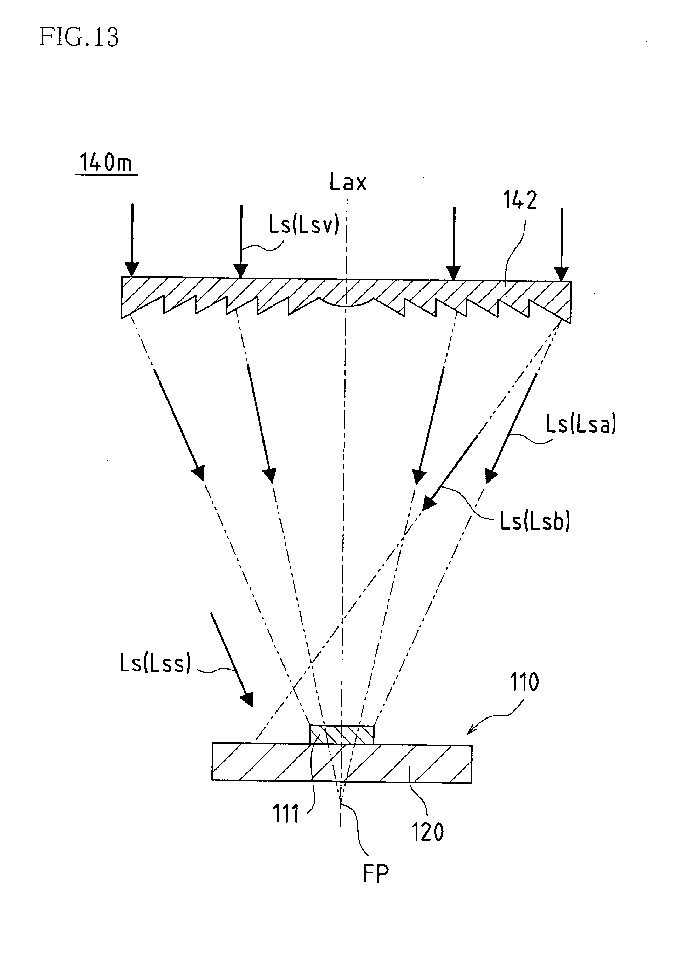

FIG. 13 is a cross-sectional view showing a configuration of a concentrating solar power generation module that is be applied to a sun-tracking concentrating solar power generation apparatus of Conventional Example 2.

A concentrating solar power generation module 140m according to Conventional Example 2 includes a concentrating lens 142 that receives and concentrates sunlight Lsv (sunlight Ls) that is incident perpendicularly on the incidence surface in parallel with the optical axis Lax and a solar cell 110 that photoelectrically converts the sunlight Ls (sunlight Lsa) concentrated by the concentrating lens 142. The solar cell 110 includes a solar cell element 111 that photoelectrically converts the sunlight Lsa concentrated to a focal position FP by the concentrating lens 142 and a receiver substrate 120 on which the solar cell element 111 is placed.

The sun-tracking concentrating solar power generation apparatus of Conventional Example 2 employs the concentrating solar power generation module 140m, which can provide a high concentration magnification through the action of the concentrating lens 142.

A sun-tracking concentrating solar power generation apparatus having a high concentration magnification generally concentrates sunlight by using a concentrating lens 142. However, because the refraction by the concentrating lens 142 is slightly different for each of a wide variety of wavelengths of sunlight Ls, refraction that is significantly different from normal may take place depending on the wavelength range (wavelengths in the short wavelength range, in particular, of the wavelength sensitivity range of the solar cell element 111), as a result of which sunlight Ls (sunlight Lsb) that is not concentrated to the solar cell element 111 due to the refraction state significantly different from normal may be generated.

In addition, because positional shift or the like occurs due to an alignment error between the concentrating lens 142 and the solar cell element 111 or the difference in temperature characteristics between the members that constitute the solar power generation module 140m, sunlight Ls (sunlight Lss) that has undergone positional shift to a region other than the solar cell element 111 and thus is not concentrated may be generated, as is the case where different refraction takes place.

Accordingly, the sunlight Ls (sunlight Lsb, Lss) that is not concentrated to the solar cell element 111 due to the difference in the refractive state depending on the wavelength range and the positional shift between constituent members poses a problem in that the substantial amount of light that is incident on the solar cell element 111 decreases, reducing the power generation (output) of the solar cell element 111, and causing a loss.

In addition, when sunlight Lss that has undergone positional shift is irradiated to a region other than the solar cell element 111, a problem arises in that the temperature of the members (for example, an insulating film, wiring, etc. provided on the receiver substrate 120) irradiated with the sunlight Lss increases due to the thermal energy of the displaced sunlight Lss, and the members may be fire damaged (damaged) in some cases.

The solar cell element 111 has another problem in that it generates heat due to the concentrated sunlight Lsa and the power generation (output) is reduced as a result.
[Patent Document 1] JP 2002-289896A
[Patent Document 2] JP 2002-289897A
[Patent Document 3] JP 2002-289898A
[Patent Document 4] JP 2006-278581A
[Patent Document 5] JP 2007-201109A

### Disclosure of Invention

### Problems to be Solved by the Invention

The present invention has been conceived under such circumstances, and it is a first object of the present invention to provide a highly heat-resistant and reliable solar cell that provides improved light-concentrating efficiency and photoelectric conversion efficiency by providing a solar cell including: a solar cell element; a receiver substrate on which the solar cell element is placed; a columnar optical member that irradiates, without loss, sunlight concentrated by a concentrating lens to the solar cell element; and a holding portion that holds the columnar optical member, wherein the holding portion includes a frame-shaped abutting frame member that is abutted against a side surface of the columnar optical member and that is configured to have a thickness in a direction from an incidence surface to an irradiation surface and a support that is disposed away from the columnar optical member and that supports the abutting frame member, the side surface of the columnar optical member is inclined so as to totally reflect sunlight in a direction of the irradiation surface, and an incidence surface concentrated light beam region formed on the incidence surface by the concentrated sunlight is located inside the incidence surface, thereby preventing fluctuation of light-concentrating characteristics to improve the light-concentrating characteristics and improving heat dissipation.

It is a second object of the present invention to provide a highly heat-resistant and reliable concentrating solar power generation module that provides improved power generation efficiency and power generation by providing a solar power generation module including a solar cell that has improved light-concentrating efficiency and heat dissipation and that photoelectrically converts sunlight concentrated by a concentrating lens.

It is a third object of the present invention to provide a solar cell manufacturing method by which it is possible to manufacture, with high productivity and low cost, a highly heat-resistant and reliable solar cell having improved light-concentrating efficiency and photoelectric conversion efficiency, by providing a solar cell manufacturing method for manufacturing a solar cell including a receiver substrate on which a solar cell element is placed, a columnar optical member that irradiates, without loss, sunlight concentrated by a concentrating lens to the solar cell element, a holding portion that is provided in a standing manner on the receiver substrate and that includes a frame-shaped abutting frame member abutted against a side surface of the columnar optical member and a support that is disposed away from the columnar optical member and that supports the abutting frame member, the method including: a support fixation step of fixing the support to the receiver substrate; a translucent resin injection step of injecting a translucent resin inside the inner resin stopper portion; and a columnar optical member placement step of placing an irradiation surface on the translucent resin with the columnar optical member abutted against the abutting frame member.

It is a fourth object of the present invention to provide a highly heat-resistant, reliable and weather-resistant solar cell having improved light-concentrating characteristics and heat dissipation that provides improved power generation efficiency and power generation by including a columnar optical member that irradiates, without loss, sunlight concentrated by a concentrating lens to the solar cell element, and an optical holding portion that is placed on the receiver substrate and that holds the columnar optical member.

It is a fifth object of the present invention to provide a highly heat-resistant, reliable and weather-resistant concentrating solar power generation module that provides improved power generation efficiency and power generation by providing a concentrating solar power generation module including a solar cell that photoelectrically converts sunlight concentrated by a concentrating lens and that has improved light-concentrating characteristics and heat dissipation.

It is a sixth object of the present invention to manufacture, with high productivity and low cost, a highly heat-resistant, reliable and weather-resistant solar cell that provides improved power generation efficiency and power generation by providing a solar cell manufacturing method for manufacturing a solar cell including a columnar optical member that irradiates, without loss, sunlight concentrated by a concentrating lens to the solar cell element, and an optical holding portion that is placed on the receiver substrate and that holds the columnar optical member by a holding wall, the method including a resin injection step of injecting a sealing resin for forming a resin sealing portion into a space formed by the optical holding portion (holding wall) and the receiver substrate, and an optical member placement step of placing the columnar optical member on the holding wall, thus aligning the optical holding portion with the columnar optical member highly accurately by a simple process, and improving the light-concentrating characteristics and the heat dissipation

### Means for solving the Problems

A first solar cell according to the present invention is a solar cell including: a solar cell element that photoelectrically converts sunlight concentrated by a concentrating lens; a receiver substrate on which the solar cell element is placed; a columnar optical member having an incidence surface on which the concentrated sunlight is incident and an irradiation surface that is disposed facing the solar cell element and that irradiates sunlight to the solar cell element; and a holding portion that is provided in a standing manner on the receiver substrate and that holds the columnar optical member, wherein the holding portion includes a frame-shaped abutting frame member that is abutted against a side surface of the columnar optical member and that is configured to have a thickness in a direction from the incidence surface to the irradiation surface, and a support that is disposed away from the columnar optical member and that supports the abutting frame member, the side surface is inclined such that incident sunlight is totally reflected in a direction of the irradiation surface, and the incidence surface is configured of a size such that an incidence surface concentrated light beam region that is formed on the incidence surface by a concentrated light beam region formed by the concentrated sunlight is locatable inside the incidence surface.

This configuration enables the incidence surface concentrated light beam region to be reliably located within the region of the incidence surface to prevent fluctuation of the light-concentrating characteristics when the concentrated sunlight (concentrated light beam region) has undergone positional shift with respect to the center of the columnar optical member, and also allows heat applied by concentrated sunlight on the columnar optical member to be dispersed in the surrounding region by the side surface and the abutting frame member, so that it is possible to provide a highly heat-resistant and reliable solar cell having improved light-concentrating efficiency and photoelectric conversion efficiency.

In the first solar cell of the present invention, the side surface has an angle of inclination of 8 to 20 degrees relative to a direction perpendicular to the irradiation surface.

This configuration enables sunlight that is incident on the columnar optical member to be totally reflected by the side surface with reliability and high accuracy and to be irradiated to the solar cell element, so that it is possible to improve the light-concentrating efficiency and the photoelectric conversion efficiency.

In the first solar cell of the present invention, the irradiation surface is configured of a size that is locatable inside the solar cell element.

This configuration can prevent undesired sunlight that does not contribute to photoelectric conversion from being irradiated to the receiver substrate, so that it is possible to prevent the receiver substrate from suffering from fire damage, thus providing a highly reliable solar cell.

In the first solar cell of the present invention, the abutting frame member is configured in a rectangular shape, and the support is disposed at four corners of the abutting frame member in a columnar manner.

This configuration makes it possible to align the abutting frame member with the columnar optical member highly accurately, and also achieve effective heat dissipation of the solar cell element and the columnar optical member by a chimney effect in the space provided around the solar cell element and around the columnar optical member, so that it is possible to improve the photoelectric conversion efficiency

A first concentrating solar power generation module according to the present invention is a concentrating solar power generation module including: a concentrating lens that concentrates and causes sunlight to be incident on the solar cell; and a solar cell that photoelectrically converts the sunlight concentrated by the concentrating lens, wherein the solar cell is the first solar cell according to the present invention.

With this configuration, the concentrating efficiency will not be reduced even if the incidence surface concentrated light beam region formed by concentrated sunlight on the incidence surface has undergone positional shift with respect to the center of the incidence surface, so that it is possible to provide a highly heat-resistant and highly reliable concentrating solar power generation module having improved light-concentrating efficiency and conversion efficiency.

In the first concentrating solar power generation module of the present invention, a minimum concentrated light beam region where the concentrated light beam region is minimized is configured to be located inside the columnar optical member.

This configuration enables the position of the focal point group formed by the concentrating lens to be located inside the columnar optical member, thus suppressing the energy density in the incidence surface concentrated light beam region, so that it is possible to prevent fire damage of the columnar optical member on the incidence surface resulting from high sunlight energy, thereby achieving a highly reliable concentrating solar power generation module.

In the first concentrating solar power generation module of the present invention, the abutting frame member is of a thickness that blocks an outer peripheral side region of a long-wavelength side concentrated light beam region formed by long-wavelength-side sunlight.

This configuration enables the long wavelength range of sunlight to be blocked by the abutting frame member, thus preventing the receiver substrate from being irradiated with the long-wavelength side of sunlight, so that it is possible to prevent a temperature increase of the receiver substrate, thus improving the photoelectric conversion efficiency.

In the first concentrating solar power generation module of the present invention, the minimum concentrated light beam region is configured to be located between a bottom portion of the abutting frame member and the irradiation surface.

This configuration makes it possible to cause the total reflection on the side surface of the columnar optical member to occur at a position that is not abutted against the abutting frame member, so that it is possible to stabilize the light-concentrating efficiency without a reflection loss caused by the abutting frame member, thus improving the output characteristics of the solar cell.

In the first concentrating solar power generation module of the present invention, a focal point group constituted by focal points of the concentrating lens that are displaced with a temperature change of the concentrating lens is located between the bottom portion and the irradiation surface.

This configuration makes it possible to cause the total reflection on the side surface to occur in a position that is not abutted against the abutting frame member when the focal points have been displaced by a temperature change of the concentrating lens, thus stabilizing the light-concentrating efficiency and hence the output characteristics of the solar cell.

In the first concentrating solar power generation module of the present invention, in an intermittent sun-tracking control mode in which the position of the solar cell is moved ahead of the sun toward a destination of the sun on the solar orbit at specific time intervals, the incidence surface concentrated light beam region is located inside the incidence surface.

This configuration can stabilize the light-concentrating efficiency of the solar cell by suppressing the fluctuation of the light-concentrating efficiency even in the case of performing an intermittent sun-tracking control in which the module is moved ahead of the sun toward a destination of the sun, so that it is possible to stabilize the output characteristics of the solar cell, thus providing a highly reliable concentrating solar power generation module.

A first solar cell manufacturing method according to the present invention is a solar cell manufacturing method for manufacturing a solar cell including: a solar cell element that photoelectrically converts sunlight concentrated by a concentrating lens; a receiver substrate on which the solar cell element is placed; a columnar optical member having an incidence surface on which the concentrated sunlight is incident and an irradiation surface that is disposed facing the solar cell element and that irradiates sunlight to the solar cell element; and a holding portion provided in a standing manner on the receiver substrate, the holding portion including a frame-shaped abutting frame member abutted against a side surface of the columnar optical member and a support that is disposed away from the columnar optical member and that supports the abutting frame member, the method including: a substrate preparation step of preparing the receiver substrate on which the solar cell element is placed; a resin stopper portion formation step of applying an adhesive resin to the receiver substrate to form an inner resin stopper portion into which a translucent resin for sealing the solar cell element with resin will be injected and an outer resin stopper portion to which the support will be fixed outside the inner resin stopper portion; a support fixation step of fixing the support to the receiver substrate by bonding the support to the outer resin stopper portion and curing the adhesive resin; a translucent resin injection step of injecting the translucent resin inside the inner resin stopper portion; a columnar optical member placement step of placing the irradiation surface on the translucent resin with the columnar optical member abutted against the abutting frame member; and a resin sealing portion formation step of curing the translucent resin to form a resin sealing portion.

This configuration enables the incidence surface concentrated light beam region to be located within the region of the incidence surface to prevent fluctuation of the light-concentrating characteristics when the concentrated sunlight (concentrated light beam region) has undergone positional shift with respect to the center of the columnar optical member, and also allows the heat applied by the concentrated sunlight to the columnar optical member to be dispersed by the abutting frame member, so that it is possible to manufacture a highly heat-resistant and reliable solar cell having improved light-concentrating efficiency and photoelectric conversion efficiency with ease and high accuracy.

A second solar cell according to the present invention is a solar cell including: a solar cell element that photoelectrically converts sunlight concentrated by a concentrating lens; a receiver substrate on which the solar cell element is placed; and a resin sealing portion for sealing the solar cell element with resin, wherein the solar cell further includes a columnar optical member forming a light-guiding path for guiding the concentrated sunlight to the solar cell element, and an optical holding portion that has a holding wall for holding the columnar optical member and that is placed on the receiver substrate so as to cover the resin sealing portion.

This configuration makes it possible to secure a light-guiding path having high positional accuracy and stability and achieve light-concentrating characteristics by which sunlight can be concentrated highly accurately over a large wavelength range, so that it is possible to provide a highly heat-resistant, reliable and weather-resistant solar cell having improved light-concentrating characteristics and heat dissipation that provides improved power generation efficiency and power generation by preventing a reduction in power generation efficiency and a temperature increase resulting from positional shift of concentrated sunlight.

In the second solar cell of the present invention, the columnar optical member has an inclined optical path surface that concentrates sunlight to the solar cell element, and the holding wall is configured as an inclined holding surface in conformity with the inclined optical path surface.

This configuration makes it possible to self-align the columnar optical member with the optical holding portion, and allow the columnar optical member to be held by the holding wall with high accuracy, so that it is possible to position the light-guiding path with high accuracy, thus improving the light-concentrating characteristics.

In the second solar cell of the present invention, the optical holding portion is abutted against a metal base of the receiver substrate.

This configuration can reduce the heat resistance between the receiver substrate and the optical holding portion to dissipate the heat conducted from the solar cell element to the receiver substrate efficiently, so that it is possible to improve the power generation efficiency and the reliability.

In the second solar cell of the present invention, the optical holding portion includes a comb tooth-shaped fin on an outer peripheral side surface thereof.

This configuration can further improve the heat dissipation characteristics, thus further improving the power generation efficiency and the reliability

In the second solar cell of the present invention, the columnar optical member is configured as a quadrangular prism, and the optical holding portion includes groove-shaped notch portions respectively surrounding axial corner portions of the quadrangular prism.

This configuration can prevent the columnar optical member from being damaged by the optical holding portion at the axial corner portions, allows the columnar optical member to be placed on the optical holding portion with reliability and high accuracy, and enables the defoaming and filling of the sealing resin filled between the columnar optical member and the optical holding portion to be performed reliably, so that it is possible to define (position) the light-guiding path highly accurately.

In the second solar cell of the present invention, a thickness of the resin sealing portion is configured to be smaller between the columnar optical member and the solar cell element than in a surrounding region thereof.

This configuration enables the surface (the irradiation surface) of the columnar optical member that faces the solar cell element to be reliably positioned adjacent to the solar cell element, so that it is possible to effectively irradiate sunlight concentrated by the columnar optical member to the solar cell element. Furthermore, it is possible to prevent a temperature increase of the receiver substrate in the surrounding region, so that it is possible to improve the heat resistance, thus providing a highly reliable and weather-resistant solar cell.

A second concentrating solar power generation module according to the present invention is a concentrating solar power generation module including: a concentrating lens that concentrates sunlight; and a solar cell that photoelectrically converts sunlight concentrated by the concentrating lens, wherein the solar cell is the second solar cell according to the present invention.

This configuration makes it possible to secure a light-guiding path having high positional accuracy and stability and achieve light-concentrating characteristics by which sunlight can be concentrated highly accurately over a large wavelength range, so that it is possible to provide a highly heat-resistant, reliable and weather-resistant concentrating solar power generation module having improved light-concentrating characteristics and heat dissipation that provides improved power generation efficiency and power generation by preventing a reduction in power generation efficiency and a temperature increase resulting from positional shift of concentrated sunlight.

A second solar cell manufacturing method according to the present invention is a solar cell manufacturing method for manufacturing a solar cell including: a solar cell element that photoelectrically converts sunlight concentrated by a concentrating lens; a receiver substrate on which the solar cell element is placed; a resin sealing portion for sealing the solar cell element with resin; a columnar optical member forming a light-guiding path for guiding the concentrated sunlight to the solar cell element; and an optical holding portion that has a holding wall for holding the columnar optical member and that is placed on the receiver substrate so as to cover the resin sealing portion, the method including: an optical holding portion preparation step of preparing the optical holding portion by forming metal; an optical holding portion placement step of placing the optical holding portion so as to abut against the receiver substrate at the outer periphery of the solar cell element; a resin injection step of injecting a sealing resin for forming the resin sealing portion into a space formed by the optical holding portion and the receiver substrate; and an optical member placement step of placing the columnar optical member on the holding wall.

This configuration makes it possible to position the optical holding portion with the columnar optical member highly accurately by a simple process, and the light-guiding path for effectively guiding the sunlight with high accuracy and the optical holding portion can be formed easily, so that it is possible to manufacture, with good productivity and low cost, a highly heat-resistant, reliable and weather-resistant solar cell having improved light-concentrating characteristics and heat dissipation that provides improved power generation efficiency and power generation by preventing a reduction in power generation efficiency and a temperature increase resulting from positional shift of concentrated sunlight.

### Effects of the Invention

The first solar cell of the present invention is a solar cell including: a solar cell element that photoelectrically converts sunlight concentrated by a concentrating lens; a receiver substrate on which the solar cell element is placed; a columnar optical member having an incidence surface on which the concentrated sunlight is incident and an irradiation surface that is disposed facing the solar cell element and that irradiates sunlight to the solar cell element; and a holding portion that is provided in a standing manner on the receiver substrate and that holds the columnar optical member, wherein the holding portion includes a frame-shaped abutting frame member that is abutted against a side surface of the columnar optical member and that is configured to have a thickness in a direction from the incidence surface to the irradiation surface, and a support that is disposed away from the columnar optical member and that supports the abutting frame member, the side surface is inclined such that incident sunlight is totally reflected in a direction of the irradiation surface, and the incidence surface is configured of a size such that an incidence surface concentrated light beam region that is formed on the incidence surface by a concentrated light beam region formed by the concentrated sunlight is locatable inside the incidence surface. Accordingly, it is possible to achieve an effect of enabling the incidence surface concentrated light beam region to be reliably located within the region of the incidence surface to prevent fluctuation of the light-concentrating characteristics when the concentrated sunlight (concentrated light beam region) has undergone positional shift with respect to the center of the columnar optical member, and also allowing heat applied by concentrated sunlight on the columnar optical member to be dispersed in the surrounding region by the side surface and the abutting frame member, so that it is possible to provide a highly heat-resistant and reliable solar cell having improved light-concentrating efficiency and photoelectric conversion efficiency.

The first concentrating solar power generation module of the present invention is a concentrating solar power generation module including: a concentrating lens that concentrates and causes sunlight to be incident on the solar cell; and a solar cell that photoelectrically converts the sunlight concentrated by the concentrating lens, wherein the solar cell is the first solar cell according to the present invention. Accordingly, the concentrating efficiency will not be reduced even if the incidence surface concentrated light beam region formed by concentrated sunlight on the incidence surface has undergone positional shift with respect to the center of the incidence surface, so that it is possible to provide a highly heat-resistant and highly reliable concentrating solar power generation module having improved light-concentrating efficiency and conversion efficiency

The first solar cell manufacturing method of the present invention is a solar cell manufacturing method for manufacturing a solar cell including: a solar cell element that photoelectrically converts sunlight concentrated by a concentrating lens; a receiver substrate on which the solar cell element is placed; a columnar optical member having an incidence surface on which the concentrated sunlight is incident and an irradiation surface that is disposed facing the solar cell element and that irradiates sunlight to the solar cell element; and a holding portion provided in a standing manner on the receiver substrate, the holding portion including a frame-shaped abutting frame member abutted against a side surface of the columnar optical member and a support that is disposed away from the columnar optical member and that supports the abutting frame member, the method including: a substrate preparation step of preparing the receiver substrate on which the solar cell element is placed; a resin stopper portion formation step of applying an adhesive resin to the receiver substrate to form an inner resin stopper portion into which a translucent resin for sealing the solar cell element with resin will be injected and an outer resin stopper portion to which the support will be fixed outside the inner resin stopper portion; a support fixation step of fixing the support to the receiver substrate by bonding the support to the outer resin stopper portion and curing the adhesive resin; a translucent resin injection step of injecting the translucent resin inside the inner resin stopper portion; a columnar optical member placement step of placing the irradiation surface on the translucent resin with the columnar optical member abutted against the abutting frame member; and a resin sealing portion formation step of curing the translucent resin to form a resin sealing portion. Accordingly, it is possible to enable the incidence surface concentrated light beam region to be located within the region of the incidence surface to prevent fluctuation of the light-concentrating characteristics when concentrated sunlight (concentrated light beam region) has undergone positional shift with respect to the center of the columnar optical member, and also to allow the heat applied by concentrated sunlight to the columnar optical member to be dispersed by the abutting frame member, so that it is possible to achieve an effect of manufacturing a highly heat-resistant and reliable solar cell having improved light-concentrating efficiency and photoelectric conversion efficiency with ease and high accuracy.

The second solar cell of the present invention is a solar cell including: a solar cell element that photoelectrically converts sunlight concentrated by a concentrating lens; a receiver substrate on which the solar cell element is placed; and a resin sealing portion for sealing the solar cell element with resin, wherein the solar cell further includes a columnar optical member forming a light-guiding path for guiding the concentrated sunlight to the solar cell element, and an optical holding portion that has a holding wall for holding the columnar optical member and that is placed on the receiver substrate so as to cover the resin sealing portion. Accordingly it is possible to secure a light-guiding path having high positional accuracy and stability and achieve light-concentrating characteristics by which sunlight can be concentrated highly accurately over a large wavelength range, so that it is possible to obtain an effect of improving the light-concentrating characteristics and the heat dissipation and increasing the power generation efficiency and the power generation by preventing a reduction in power generation efficiency and a temperature increase resulting from positional shift of concentrated sunlight, thus improving the heat-resistance, reliability and weather-resistance.

The second concentrating solar power generation module of the present invention is a concentrating solar power generation module including: a concentrating lens that concentrates sunlight; and a solar cell that photoelectrically converts sunlight concentrated by the concentrating lens, wherein the solar cell is the second solar cell according to the present invention. Accordingly, it is possible to secure a light-guiding path having high positional accuracy and stability and achieve light-concentrating characteristics by which sunlight can be concentrated highly accurately over a large wavelength range, so that it is possible to obtain an effect of improving the light-concentrating characteristics and the heat dissipation and increasing the power generation efficiency and the power generation by preventing a reduction in power generation efficiency and a temperature increase resulting from positional shift of concentrated sunlight, thus improving the heat-resistance, reliability and weather-resistance.

The second solar cell manufacturing method of the present invention is a solar cell manufacturing method for manufacturing a solar cell including: a solar cell element that photoelectrically converts sunlight concentrated by a concentrating lens; a receiver substrate on which the solar cell element is placed; a resin sealing portion for sealing the solar cell element with resin; a columnar optical member forming a light-guiding path for guiding the concentrated sunlight to the solar cell element; and an optical holding portion that has a holding wall for holding the columnar optical member and that is placed on the receiver substrate so as to cover the resin sealing portion, the method including: an optical holding portion preparation step of preparing the optical holding portion by forming metal; an optical holding portion placement step of placing the optical holding portion so as to abut against the receiver substrate at the outer periphery of the solar cell element; a resin injection step of injecting a sealing resin for forming the resin sealing portion into a space formed by the optical holding portion and the receiver substrate; and an optical member placement step of placing the columnar optical member on the holding wall. Accordingly, it is possible to position the optical holding portion with the columnar optical member highly accurately by a simple process, and the light-guiding path for effectively guiding the sunlight with high accuracy and the optical holding portion can be formed easily, so that it is possible to obtain an effect of manufacturing, with good productivity and low cost, a highly heat-resistant, reliable and weather-resistant solar cell having improved light-concentrating characteristics and heat dissipation that provides improved power generation efficiency and power generation by preventing a reduction in power generation efficiency and a temperature increase resulting from positional shift of concentrated sunlight.

### Brief Description of Drawings

[FIG. 1A] FIG. 1A is a perspective side view perspectively showing a schematic configuration of a solar cell and a concentrating solar power generation module according to Embodiment 1 of the present invention on a plane including the optical axis.
[FIG. 1B] FIG. 1B is an oblique view showing an appearance of a holding portion and a columnar optical member of the solar cell shown in FIG. 1A as viewed from obliquely above.
[FIG. 2] FIG. 2 is a side view conceptually showing the characteristics for sunlight wavelengths of a solar cell and a concentrating solar power generation module according to Embodiment 2 of the present invention.
[FIG. 3A] FIG. 3A is a side view conceptually showing a displacement state of a focal point with respect to sunlight wavelengths due to the temperature characteristics of a concentrating lens in a solar cell and a concentrating solar power generation module according to Embodiment 3 of the present invention.
[FIG. 3B] FIG. 3B is a plan view conceptually showing a displacement state of an incidence surface concentrated light beam region on an incidence surface of the solar cell shown in FIG. 3A.

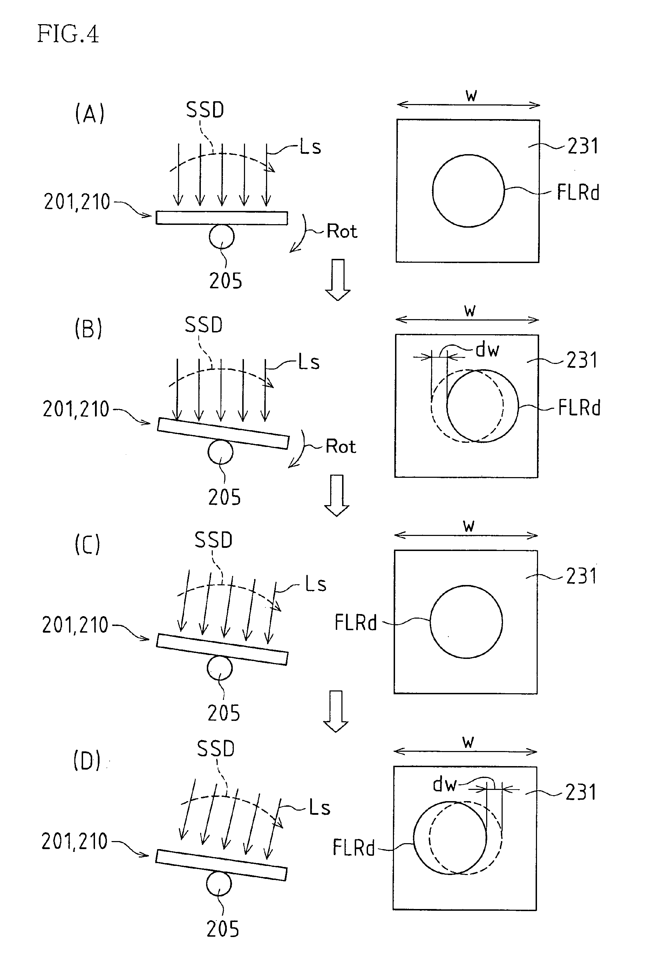

[FIG. 4] FIG. 4 shows sun-tracking state conceptual diagrams conceptually illustrating the relationship between a sun-tracking state and an incidence surface concentrated light beam region formed on an incidence surface when a concentrating solar power generation module according to Embodiment 4 of the present invention is subjected to an intermittent sun-tracking control, where (A) shows a state in which the concentrating solar power generation module is directly opposite the sunlight, (B) shows a state in which the concentrating solar power generation module has been moved ahead of the sunlight, (C) shows a state in which the moved concentrating solar power generation module is again directly opposite the sunlight as a result of movement of the sunlight, and (D) shows a state in which a delay has occurred in the concentrating solar power generation module as a result of movement of the sunlight.
[FIG. 5] FIG. 5 is an explanatory drawing conceptually illustrating the relationship between a set angle shift and an incidence surface concentrated light beam region formed on an incidence surface when an assembly error has occurred between a concentrating lens and a solar cell of a concentrating solar power generation module according to Embodiment 5 of the present invention.
[FIG. 6A] FIG. 6A is a process diagram showing a substrate preparation step of preparing a receiver substrate on which a solar cell is placed by a solar cell manufacturing method according to Embodiment 6 of the present invention.
[FIG. 6B] FIG. 6B is a process diagram showing a resin stopper portion formation step of forming an inner resin stopper portion and an outer resin stopper portion by the solar cell manufacturing method according to Embodiment 6 of the present invention.
[FIG. 6C] FIG. 6C is a process diagram showing a support fixation step of fixing a support of a holding portion to the receiver substrate by the solar cell manufacturing method according to Embodiment 6 of the present invention.
[FIG. 6D] FIG. 6D is a process diagram showing a translucent resin injection step of injecting a translucent resin inside the inner resin stopper portion by the solar cell manufacturing method according to Embodiment 6 of the present invention.
[FIG. 6E] FIG. 6E is a process diagram showing a columnar optical member placement step of placing an irradiation surface on the translucent resin with the columnar optical member abutted against the holding portion by the solar cell manufacturing method according to Embodiment 6 of the present invention.
[FIG. 7] FIG. 7 is a cross-sectional view showing a solar cell and a concentrating solar power generation module according to Embodiment 7 of the present invention.
[FIG. 8] FIG. 8 is an enlarged plan view showing a state in which the solar cell shown in FIG. 7 is viewed in enlargement from the concentrating lens side.
[FIG. 9] FIG. 9 is an enlarged cross-sectional view showing a cross section as viewed in the direction of arrows Y-Y in FIG. 8.
[FIG. 10A] FIG. 10A is a process diagram illustrating a solar cell manufacturing method according to Embodiment 8 of the present invention, showing a state in which a solar cell element is placed on a receiver substrate in a cross section as viewed in the direction of arrows X-X in FIG. 8.
[FIG. 10B] FIG. 10B is a process diagram illustrating the solar cell manufacturing method according to Embodiment 8 of the present invention, showing a state in which an optical holding portion is placed on a receiver substrate in a cross section as viewed in the direction of arrows X-X in FIG. 8.
[FIG. 10C] FIG. 10C is a process diagram illustrating a solar cell manufacturing method according to Embodiment 8 of the present invention, showing a state in which a sealing resin has been injected into the space that the optical holding portion forms between the receiver substrate in a cross section as viewed in the direction of arrows X-X in FIG. 8.
[FIG. 10D] FIG. 10D is a process diagram illustrating the solar cell manufacturing method according to Embodiment 8 of the present invention, showing a state in which a columnar optical member is placed on the optical holding portion in a cross section as viewed in the direction of arrows X-X in FIG. 8.
[FIG. 11] FIG. 11 is an oblique view schematically showing a configuration of a concentrating solar power generation unit according to Embodiment 9 of the present invention.
[FIG. 12] FIG. 12 is a cross-sectional view showing an example of a configuration of a concentrating solar power generation module that is applied to a sun-tracking concentrating solar power generation apparatus of Conventional Example 1.
[FIG. 13] FIG. 13 is a cross-sectional view showing a configuration of a concentrating solar power generation module that is applied to a sun-tracking concentrating solar power generation apparatus of Conventional Example 2.

### Description of Reference Numerals

201 Concentrating Solar Power Generation Module
205 Sun-Tracking Control Portion
210 Solar Cell
211 Solar Cell Element
220 Receiver Substrate
221 Inner Resin Stopper Portion
222 Outer Resin Stopper Portion
225 Resin Sealing Portion
230 Columnar Optical Member
231 Incidence Surface
232 Irradiation Surface
233 Side Surface
240 Holding Portion
241 Abutting Frame Member
241b Bottom Portion
241g Groove Portion
242 Support
250 Concentrating Lens
FLR Concentrated Light Beam Region
FLRb Medium- and Short-Wavelength Side Concentrated Light Beam Region
FLRc Long-Wavelength Side Concentrated Light Beam Region
FLRcs Outer Peripheral Side Region
FLRd Incident Surface Concentrated Light Beam Region
FLRs Minimum Concentrated Light Beam Region
FLR (T1) Concentrated Light Beam Region (Temperature T1)
FLR (T2) Concentrated Light Beam Region (Temperature T2)
FLR (T3) Concentrated Light Beam Region (Temperature T3)
FLRd (T1) Incident Surface Concentrated Light Beam Region (Temperature T1)
FLRd (T2) Incident Surface Concentrated Light Beam Region (Temperature T2)
FLRd (T3) Incident Surface Concentrated Light Beam Region (Temperature T3)
FP Focal Point
FPg Focal Point Group
FP (T1) Focal Point (Temperature T1)
FP (T2) Focal Point (Temperature T2)
FP (T3) Focal Point (Temperature T3)
Lax Optical Axis
Ls Sunlight
Sfp Focal Point Shift
SSD Sun Shift Direction
t Thickness
α Set Angle Shift
θ Angle of Inclination (Inclination of Side Surface 233)
310 Solar Cell
311 Solar Cell Element
320 Receiver Substrate
321 Adhesive Portion
340 Concentrating Solar Power Generation Unit
340m Concentrating Solar Power Generation Module
342 Concentrating Lens
344 Elongated Frame
370 Columnar Optical Member (Light-Guiding Path)
370c Axial Corner Portion
370f Incidence Surface
370r Irradiation Surface
370s Inclined Optical Path Surface
372 Optical Holding Portion
372g Notch Portion
372h Fin
372w Holding Wall (Inclined Holding Surface)
373 Resin Sealing Portion
373r Sealing Resin
381 Column
Af Light-Concentrating Region
Hh, Hp Height
Lax Optical Axis
Ls, Lsa, Lsb, Lss Sunlight
Roth Horizontal Rotation
Rotv Vertical Rotation
Tr, Ts Thickness
Wb Position of Center of Gravity

### Best Mode for Carrying Out the Invention

Hereinafter, embodiments of the present invention will be described based on the drawings.

### Embodiment 1

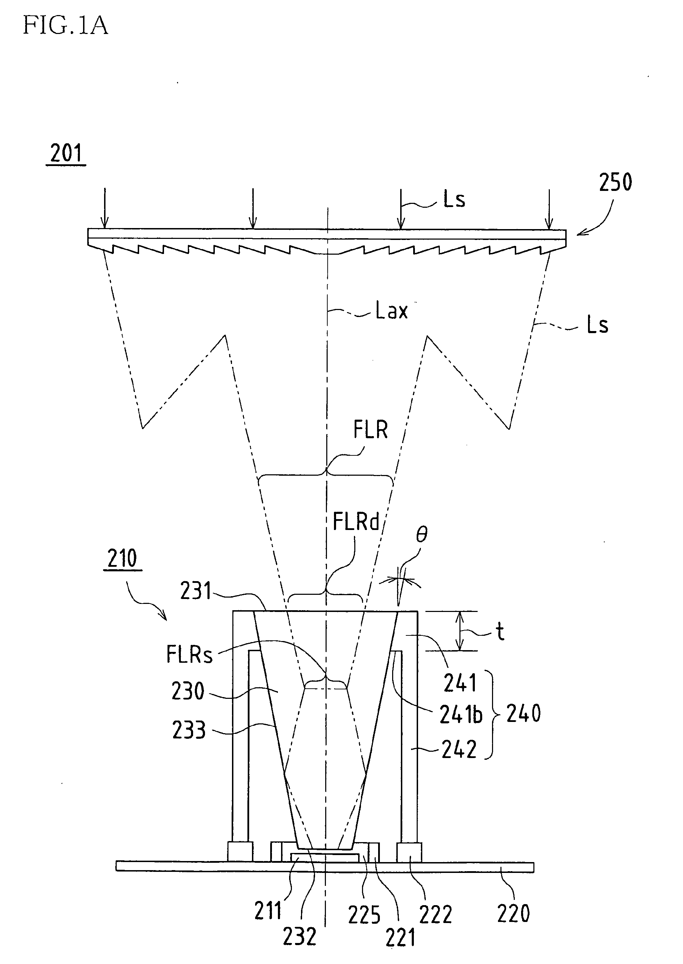

A solar cell and a concentrating solar power generation module according to this embodiment will be described based on FIGS. 1A to 3B.

FIG. 1A is a perspective side view perspectively showing a schematic configuration of a solar cell and a concentrating solar power generation module according to Embodiment 1 of the present invention on a plane including the optical axis.

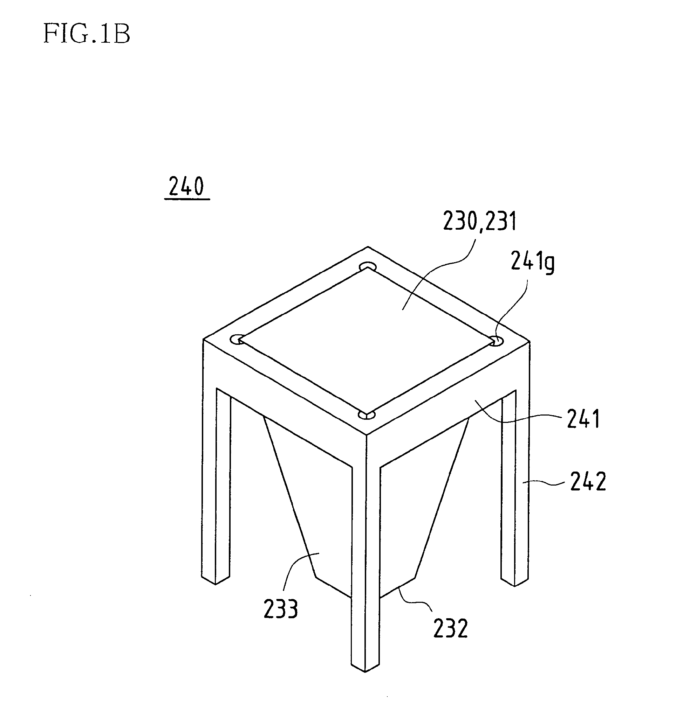

FIG. 1B is an oblique view showing an appearance of a holding portion and a columnar optical member of the solar cell shown in FIG. 1A as viewed from obliquely above.

A solar cell 210 according to this embodiment includes a solar cell element 211 that photoelectrically converts sunlight Ls concentrated by a concentrating lens 250, a receiver substrate 220 on which the solar cell element 211 is placed, a columnar optical member 230 having an incidence surface 231 on which the concentrated sunlight Ls is incident and an irradiation surface 232 that is disposed facing the solar cell element 211 and that irradiates the sunlight Ls to the solar cell element 211, and a holding portion 240 that is provided in a standing manner on the receiver substrate 220 and that holds the columnar optical member 230.

The holding portion 240 includes a frame-shaped abutting frame member 241 that is abutted against a side surface 233 of the columnar optical member 230 and that is configured to have a thickness t in a direction from the incidence surface 231 to the irradiation surface 232, and a support 242 that is disposed away from the columnar optical member 230 and that supports the abutting frame member 241.

The side surface 233 of the columnar optical member 230 is inclined such that incident sunlight Ls is totally reflected in a direction of the irradiation surface 232, and the incidence surface 231 of the columnar optical member 230 is configured of a size such that an incidence surface concentrated light beam region FLRd that is formed on the incidence surface 231 by a concentrated light beam region FLR formed by the concentrated sunlight Ls is locatable inside the incidence surface 231.

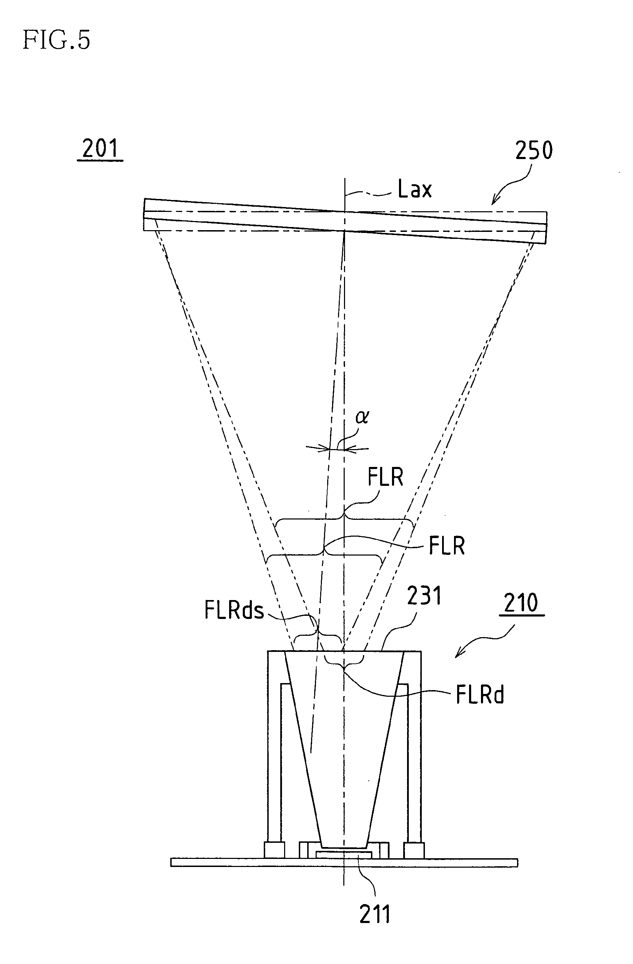

Accordingly, when the concentrated sunlight Ls (concentrated light beam region FLR) undergoes positional shift with respect to the center (optical axis Lax) of the columnar optical member 230 (see FIGS. 4 and 5), this configuration allows the incidence surface concentrated light beam region FLRd to be reliably located within the region of the incidence surface 231 to prevent fluctuation of the light-concentrating characteristics of the solar cell 210, and also enables the heat applied by the concentrated sunlight Ls to the columnar optical member 230 to be dispersed by the side surface 233 and the abutting frame member 241 into the surrounding space, so that it is possible to provide a highly heat-resistant and reliable solar cell 210 having improved light-concentrating efficiency and photoelectric conversion efficiency.

The side surface 233 has an angle of inclination θ of 8 to 20 degrees relative to a direction perpendicular to the irradiation surface 232 (the direction of the optical axis Lax, that is, a direction perpendicular to the light-receiving surface of the solar cell element 211). Accordingly, it is possible to allow sunlight Ls that is incident on the columnar optical member 230 to be totally reflected by the side surface 233 with reliability and high accuracy and to be irradiated to the solar cell element 211, so that the light-concentrating efficiency and photoelectric conversion efficiency of the solar cell 210 can be improved reliably.

The irradiation surface 232 is configured of a size that is locatable inside (the outer periphery of) the solar cell element 211. Accordingly, the sunlight Ls that is irradiated from the irradiation surface 232 to the solar cell element 211 will be reliably irradiated only to the solar cell element 211. In other words, it is possible to prevent undesired sunlight Ls that does not contribute to photoelectric conversion from being irradiated to the receiver substrate 220, so that it is possible to provide a highly reliable solar cell 210 by preventing the receiver substrate 220 on which wiring to the solar cell element 211 is formed from suffering fire damage.

The columnar optical member 230 can be formed, for example, of a glass, a heat-resistant glass, a commonly used transparent resin, of the like. It is desirable to use a material having a property that can withstand a high energy density of the concentrated sunlight Ls. In other words, a heat-resistant glass capable of withstanding a temperature increase and a rapid temperature change that could be caused by the sunlight Ls is particularly desirable, but the present invention is not limited thereto.

The abutting frame member 241 is configured in a rectangular shape, and the support 242 is disposed at four corners of the abutting frame member 241 in a columnar manner. This makes it possible to align the abutting frame member 241 with the columnar optical member 230 highly accurately, and also achieve effective heat dissipation of the solar cell element 211 and the columnar optical member 230 by a chimney effect in the space provided around the solar cell element 211 and around the columnar optical member 230 (the side surface 233), so that it is possible to improve the photoelectric conversion efficiency.

In other words, since the area of the side surface 233 in which the total reflection occurs is exposed in the space without abutting on the abutting frame member 241, the thermal energy caused by the sunlight Ls supplied to the columnar optical member 230 can be released efficiently into the space, thus making it possible to improve the heat resistance of the solar cell 210 (solar cell element 211).

Furthermore, at corner portions of the inner side of the abutting frame member 241 (the portions abutting against the columnar optical member 230), groove portions 241g corresponding to the corners of the columnar optical member 230 are formed. That is, the corners of the columnar optical member 230 are disposed in a space formed by the groove portions 241g, and therefore will not come into direct contact with the abutting frame member 241, and thus be secure from damage during assembly. Since the side surface 233 and the inner surface of the abutting frame member 241 are each configured as a plane, they can be abutted highly accurately, thus achieving high-accuracy alignment.

In addition, it is possible for the groove portions 241g to be filled with an adhesive resin to improve the adhesion between the columnar optical member 230 and the holding portion 240, thus improving the mechanical strength to increase the stability of the columnar optical member 230. Furthermore, the minimum concentrated light beam region FLRs where the concentrated light beam region FLR is minimized is configured to be located on the irradiation surface 232 side with respect to the abutting frame member 241. Accordingly, the sunlight Ls will not be irradiated to the side surface 233 on the inner surface of the abutting frame member 241, so that there will be no effect on the sunlight Ls. That is, even if the groove portions 241g are filled with an adhesive resin, there will be no harmful effect on the light-concentrating characteristics.

For the holding portion 240, it is possible to use, for example, a metal such as aluminum, iron or stainless steel, or a synthetic resin such as polyethylene. In view of the heat dissipation, thermal expansion characteristics, and the like, it is preferable to use a metal. From the viewpoint of weight reduction and cost reduction, it is preferable to use aluminum.

An inner resin stopper portion 221 is formed in the shape of a ring (in the shape of a picture frame) around the solar cell element 211, and a resin sealing portion 225 made of a translucent resin is formed inside the inner resin stopper portion 221. That is, the inner resin stopper portion 221 is used as a resin stopper when the resin sealing portion 225 is formed by providing a resin seal with a translucent resin between the solar cell element 211 and the irradiation surface 232. With the resin sealing portion 225, it is possible to reliably protect the surface of the solar cell element 211 and eliminate influences from the outside environment, thus providing a solar cell 210 having excellent weather resistance.

It is preferable that the translucent resin forming the resin sealing portion 225 has high optical transparency and excellent adhesiveness. For example, it is possible to use epoxy resin, silicone resin, and the like. The resin sealing portion 225 improves the water resistance and moisture resistance of the solar cell element 211 by covering the surface of the solar cell element 211. Additionally, the resin sealing portion 225 is bonded to the columnar optical member 230 (irradiation surface 232), and has the action of fixing the columnar optical member 230.

An outer resin stopper portion 222 is formed outside the inner resin stopper portion 221. The outer resin stopper portion 222 is disposed in order to fix the support 242 by bonding. Therefore, the outer resin stopper portion 222 can be formed only at a position corresponding to the support 242, or alternatively, can be formed in the shape of a ring (in the shape of a picture frame) as with the outer resin stopper portion 222. In the case where the outer resin stopper portion 222 is formed in the shape of a ring (in the shape of a picture frame), when the translucent resin filled into the inner resin stopper portion 221 is extruded from the inner resin stopper portion 221 by the columnar optical member 230 during formation of the resin sealing portion 225, the translucent resin will be stopped by the outer resin stopper portion 222, so that it is possible to prevent the occurrence of step defects.

It is preferable that the inner resin stopper portion 221 and the outer resin stopper portion 222 are formed of a synthetic resin having adhesiveness. For example, it is possible to use epoxy resin, silicone resin, and the like.

The concentrating solar power generation module 201 according to this embodiment includes the concentrating lens 250 that concentrates and causes the sunlight Ls to be incident on the solar cell 210, and the solar cell 210 that photoelectrically converts the sunlight Ls concentrated by the concentrating lens 250. Accordingly, even when the incidence surface concentrated light beam region FLRd formed on the incidence surface 231 by the concentrated sunlight Ls has undergone positional shift with respect to the center of the incidence surface 231 (optical axis Lax), the incidence surface concentrated light beam region FLRd can be formed inside the incidence surface 231, so that the light-concentrating characteristics will not fluctuate.

That is, the concentrating solar power generation module 201 according to this embodiment will not likely experience a reduction in light-concentrating efficiency when the incidence surface concentrated light beam region FLRd has undergone positional shift with respect to the center of the incidence surface 231, and therefore makes it possible to improve the light-concentrating efficiency and the conversion efficiency, thus achieving high heat resistance and reliability.

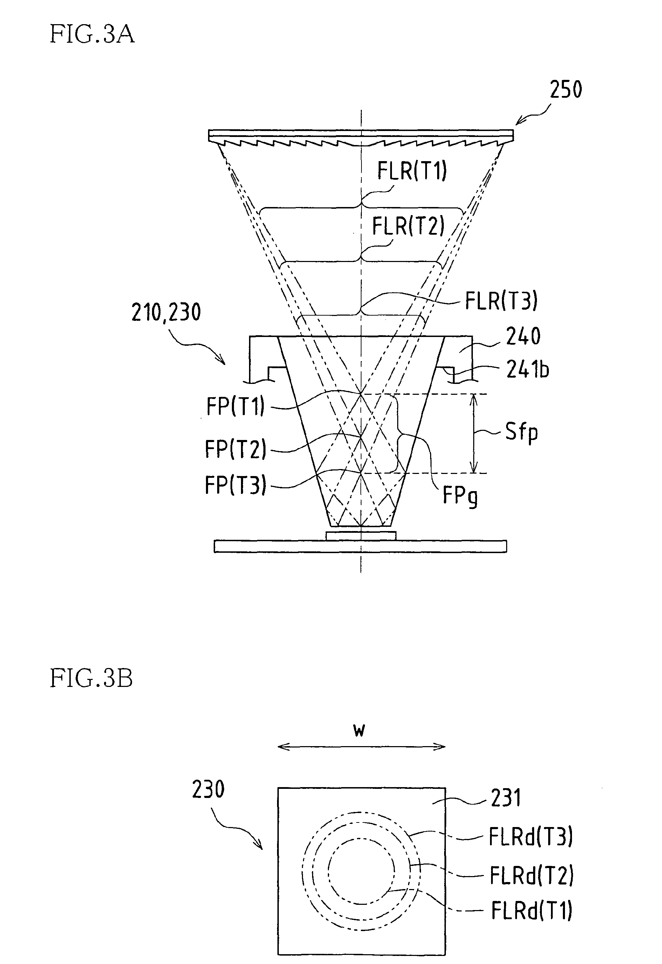

Furthermore, the minimum concentrated light beam region FLRs where the concentrated light beam region FLR is minimized is configured to be located inside the columnar optical member 230. Accordingly, the position of a focal point group FPg (see FIG. 3A) formed by the concentrating lens 250 can be located inside the columnar optical member 230, thus suppressing the energy density in the incidence surface concentrated light beam region FLRd. That is, for example, when dust has attached to the surface of the incidence surface 231, it is possible to prevent the columnar optical member 230 from being fire damaged due to the dust combusting as a result of high thermal energy caused by the concentrated sunlight Ls, so that it is possible to achieve a highly reliable concentrating solar power generation module 201.

Preferably, the minimum concentrated light beam region FLRs is configured to be located between a bottom portion 241b of the abutting frame member 241 and the irradiation surface 232. That is, since it is possible to cause the total reflection on the side surface 233 of the columnar optical member 230 to occur at a position that is not abutted against the abutting frame member 241, it is possible to stabilize the light-concentrating efficiency without causing a reflection loss by the abutting frame member 241, thus stabilizing the output characteristics of the solar cell 210.

Additionally, the size of the incidence surface concentrated light beam region FLRd can be set by optically calculating the light-concentrating characteristics, the size, and the distance of the concentrating lens 250 relative to the solar cell 210. The size and position of the minimum concentrated light beam region FLRs can be set by optically calculating the light-concentrating characteristics, the size, and the distance of the concentrating lens 250 relative to the solar cell 210, and also the size and distance of the columnar optical member 230 relative to the solar cell element 211.

### Embodiment 2

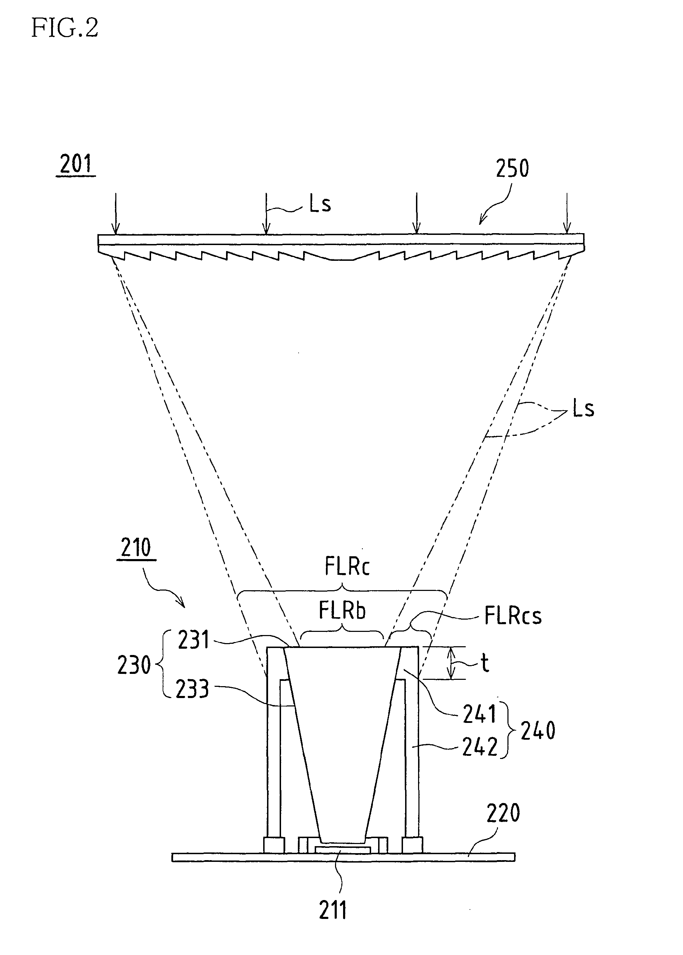

A solar cell and a concentrating solar power generation module according to this embodiment will be described based on FIG. 2. The basic configuration of the solar cell and the concentrating solar power generation module according to this embodiment is the same as in Embodiment 1, and therefore a description will be given mainly for differences with reference to the reference numerals used in Embodiment 1.

FIG. 2 is a side view conceptually showing the characteristics for sunlight wavelengths of a solar cell and a concentrating solar power generation module according to Embodiment 2 of the present invention.

The wavelength range of the sunlight Ls includes a medium- and short-wavelength side region ranging from a short wavelength of 400 nm to a medium wavelength of 1000 nm (1 µm) and a long-wavelength side region above 1 µm. Of the sunlight Ls concentrated by the concentrating lens 250, the sunlight Ls in the medium- and short-wavelength side region is concentrated in the vicinity of the center of the incidence surface 231 and forms a medium- and short-wavelength side concentrated light beam region FLRb. The sunlight Ls in the long-wavelength side region forms a long-wavelength side concentrated light beam region FLRc in the medium- and short-wavelength side concentrated light beam region FLRb and the outer periphery thereof (the outer periphery of the incidence surface 231, also a region corresponding to the abutting frame member 241).

The sunlight Ls in the medium- and short-wavelength side region (400 nm to 1000 nm) entirely contributes to the photoelectric conversion of the solar cell element 211. Accordingly, the solar cell and the concentrating solar power generation module are configured such that the medium- and short-wavelength side concentrated light beam region FLRb, which is the concentrated light beam region formed by the medium- and short-wavelength side region (400 nm to 1000 nm), is reliably irradiated to the solar cell element 211.

In this embodiment, the medium- and short-wavelength side concentrated light beam region FLRb is incident on the incidence surface 231, and travels inside the columnar optical member 230 before being totally reflected by the side surface 233. That is, the incidence surface 231 is configured so that the medium- and short-wavelength side concentrated light beam region FLRb is located inside the incidence surface 231. Conversely, the medium- and short-wavelength side concentrated light beam region FLRb is configured so as to be located inside the incidence surface 231 by the concentrating lens 250.

On the other hand, the sunlight Ls in the long-wavelength side region (above 1 µm) will not entirely contribute to the photoelectric conversion of the solar cell element 211, and the energy needed to contribute to the photoelectric conversion may be approximately two-thirds of the incident energy. The sunlight Ls in the long-wavelength side region has the action of increasing the temperature of the solar cell 210, thus reducing the photoelectric conversion efficiency.

Therefore, this embodiment employs a configuration in which an outer peripheral portion (an outer peripheral side region FLRcs on the outside of the medium- and short-wavelength side concentrated light beam region FLRb) of the long-wavelength side concentrated light beam region FLRc, which is the concentrated light beam region formed by the sunlight Ls in the long-wavelength side region (above 1 µm), is blocked by the abutting frame member 241 (thickness t). That is, in this configuration, the outer peripheral side region FLRcs of the long-wavelength side concentrated light beam region FLRc formed by the sunlight Ls in the long-wavelength side region is concentrated by the concentrating lens 250 to a position that is blocked on the outer periphery of incidence surface 231 by a region corresponding to the top face and thickness t of the abutting frame member 241.

That is, the abutting frame member 241 is of a thickness t that blocks the outer peripheral side region FLRcs of the long-wavelength side concentrated light beam region FLRc formed by the long-wavelength side region of the sunlight Ls. This configuration enables blocking the long-wavelength side region of the sunlight Ls by the abutting frame member 241 and preventing the receiver substrate 220 from being irradiated with the sunlight Ls, so that it is possible to prevent a temperature increase of the receiver substrate 220, thus improving the photoelectric conversion efficiency.

When the solar cell element 211 is a multi-junction solar cell, it is not necessary to absorb all wavelengths since the designed current value of the bottom layer is approximately 1.8 times larger than that of the top layer and the middle layer. Accordingly, providing the top face and the thickness t portion of the abutting frame member 241 with the light-shielding property for the long-wavelength side region makes it possible to avoid a temperature increase of the long-wavelength side region caused by the sunlight Ls. Conversely, by accurately aligning the incidence surface concentrated light beam region FLRd corresponding to the medium- and short-wavelength side region on the incidence surface 231, and also causing it to be totally reflected by the side surface 233, it is possible to produce a heat shield effect to prevent a decrease in output due to positional shift of the incidence surface concentrated light beam region FLRd, thus ensuring a stable output.

### Embodiment 3

A solar cell and a concentrating solar power generation module according to this embodiment will be described based on FIGS. 3A and 3B. The basic configuration of the solar cell and the concentrating solar power generation module according to this embodiment is the same as in Embodiments 1 and 2, and therefore a description will be given mainly for differences with reference to the reference numerals used in these embodiments.

FIG. 3A is a side view conceptually showing a displacement state of a focal point with respect to sunlight wavelengths due to the temperature characteristics of a concentrating lens in a solar cell and a concentrating solar power generation module according to Embodiment 3 of the present invention.

FIG. 3B is a plan view conceptually showing a displacement state of an incidence surface concentrated light beam region on an incidence surface of the solar cell shown in FIG. 3A.

A concentrating lens 250 according to this embodiment is configured, for example, as a Fresnel lens formed by silicone resin. When the temperature of the silicone resin has changed, for example, from 20°C to 40°C, the refractive index, for example, for a wavelength of 650 nm changes from 1.409 (20°C) to 1.403 (40°C) in accordance with the temperature change. In addition, the change in refractive index occurs for all wavelengths.

Therefore, during a temperature change, the concentrated light beam region FLR changes according to the temperature. For example, when temperature T1 > temperature T2 > temperature T3, the concentrated light beam region FLR (T1) at temperature T1 < the concentrated light beam region FLR (T2) at temperature T2 < the concentrated light beam region FLR (T3) at temperature T3. The relationship between the incidence surface concentrated light beam region FLRd (T1) at temperature T1, the incidence surface concentrated light beam region FLRd (T2) at temperature T2, and incidence surface concentrated light beam region FLRd (T3) at temperature T3 is such that the incidence surface concentrated light beam region FLRd (T1) < the incidence surface concentrated light beam region FLRd (T2) < the incidence surface concentrated light beam region FLRd (T3).

That is, the focal point FP (T1) at temperature T1, the focal point FP (T2) at temperature T2, and the focal point FP (T3) at temperature T3 are located in the order the focal point FP (T1), the focal point FP (T2), and the focal point FP (T3) from the incidence surface 231. Accordingly, the focal point FP (T1), the focal point FP (T2), and the focal point FP (T3) are a group of focal points FP, and constitute a focal point group FPg.

That is, when the temperature of the concentrating lens 250 has changed between temperature T1 to temperature T3, the focal point FP undergoes a focal point shift Sfp, causing fluctuation of the light-concentrating characteristics of the concentrating lens 250. Further, the incidence surface concentrated light beam region FLRd on the incidence surface 231 will be influenced by a change in refractive index and change accordingly.

The diameter of the concentrating lens 250 is set to 30 cm, for example, and the interval between the concentrating lens 250 and the solar cell element 211 is set to 30 cm, for example. For such a shape, when the incidence surface concentrated light beam region FLRd (T1) at temperature T1 (for example, 40°C) has a diameter of approximately 6.5 mm, the incidence surface concentrated light beam region FLRd (T2) at temperature T2 (for example, 30°C) has a diameter of approximately 7 mm, and the incidence surface concentrated light beam region FLRd (T3) at temperature T3 (for example, 20°C) has a diameter of approximately 7.5 mm, by setting the length w of a side of an incidence surface 231 configured as a rectangular shape to 9.4 mm, for example, the incidence surface concentrated light beam region FLRd will be always incident inside the incidence surface 231 even if there is a change in light-concentrating characteristics due to a temperature change. Accordingly, the fluctuation of the light-concentrating characteristics can be substantially prevented.

In addition, the focal point shift Sfp from the focal point FP (T1) to the focal point FP (T3) at this time was approximately 10 mm. Therefore, it is sufficient for the distance from the bottom portion 241b of the abutting frame member 241 to the irradiation surface 232 to be at least 10 mm or more.

As described above, this embodiment employs a configuration in which the focal point group FPg formed by the focal points FP of the concentrating lens 250 that are displaced with a temperature change of the concentrating lens 250 is located between the bottom portion 241b of the abutting frame member 241 and the irradiation surface 232. Accordingly, when the focal point has been displaced as a result of a temperature change of the concentrating lens 250, it is possible to cause the total reflection at the side surface 233 to occur at a position that is not abutted against the abutting frame member 241, so that it is possible to stabilize the light-concentrating efficiency, thus stabilizing the output characteristics of the solar cell 210.

Furthermore, since the focal point FP is located between the bottom portion 241b of the abutting frame member 241 and the irradiation surface 232, the position of the focal point FP can be prevented from moving to a position corresponding to the outer periphery of the holding portion 240, and the thermal energy density of the concentrated light beam region FLR on the surface of the receiver substrate 220 can be suppressed even if the sunlight Ls shines on the receiver substrate 220 in an exceptional circumstance, so that it is possible to prevent a temperature increase of the receiver substrate 220, thus avoiding fine damage.

### Embodiment 4

A solar cell and a concentrating solar power generation module according to this embodiment will be described based on FIG. 4. The basic configuration of the solar cell and the concentrating solar power generation module according to this embodiment is the same as in Embodiments 1 to 3, and therefore a description will be given mainly for differences with reference to the reference numerals used in these embodiments.

FIG. 4 shows sun-tracking state conceptual diagrams conceptually illustrating the relationship between a sun-tracking state and an incidence surface concentrated light beam region formed on an incidence surface when a concentrating solar power generation module according to Embodiment 4 of the present invention is subjected to an intermittent sun-tracking control, where (A) shows a state in which the concentrating solar power generation module is directly opposite the sunlight, (B) shows a state in which the concentrating solar power generation module has been moved ahead of the sunlight, (C) shows a state in which the moved concentrating solar power generation module is again directly opposite the sunlight as a result of movement of the sunlight, and (D) shows a state in which a delay has occurred in the concentrating solar power generation module as a result of movement of the sunlight.

A concentrating solar power generation module 201 (solar cell 210) according to this embodiment is configured to be directly opposite the sunlight Ls by what is called sun-tracking control. That is, the direction of incidence of the sunlight Ls on the concentrating solar power generation module 201 (incidence surface 231) changes along the sun shift direction SSD, so that the concentrating solar power generation module 201 is configured to be intermittently driven by the sun-tracking control portion 205 so as to swing with respect to the azimuth of the sun, and also configured to be intermittently driven so as to be tilted with respect to the altitude of the sun. To facilitate understanding, FIG. 4 only shows a state in which the module is driven so as to swing, but a similar drive control is also performed for the tilting drive as well as for the swinging drive.

In order to perform sun-tracking control efficiently, the sun-tracking control for the concentrating solar power generation module 201 is performed at specific time intervals. That is, the sun-tracking control performed by the sun-tracking control portion 205 is in what is called an intermittent sun-tracking control mode. In addition, the shape of the concentrating solar power generation module 201 (the diameter of the concentrating lens 250, and the interval between the concentrating lens 250 and the solar cell element 211) are the same as those in Embodiment 3.

The intermittent sun-tracking control can be performed, for example, as follows.

The concentrating solar power generation module 201 that was located behind the sunlight Ls (a position immediately before FIG. 4(A) is driven so as to swing in the direction indicated by arrow Rot, passing through a state of being directly opposite the sunlight Ls (FIG. 4(A)), and moving to and being fixed at a position that is past the sunlight Ls (FIG. 4(B)).

The swing angle of the concentrating solar power generation module 201 when the concentrating solar power generation module 201 has passed the sunlight Ls is, for example, +0.05 degrees at a maximum, with respect to the directly opposite position. When the length w of a side of the incidence surface 231 is 9.4 mm and the diameter of the incidence surface concentrated light beam region FLRd is 7 mm, the swing deviation dw of the incidence surface concentrated light beam region FLRd with respect to the directly opposite state is 1 mm.

The sunlight Ls again passes through a state of being directly opposite (FIG. 4(C)) while being incident on the incidence surface concentrated light beam region FLRd of the concentrating solar power generation module 201 that has been moved to a position ahead of the sunlight Ls (FIG. 4(B)), and moves to a position that is past the solar power generation module 201 (FIG. 4(D).

The swing angle when the sunlight Ls has passed the concentrating solar power generation module 201 is, for example, -0.05 degrees at a maximum, with respect to the directly opposite position. Therefore, with respect to the state in which the concentrating solar power generation module 201 has passed the sunlight Ls, the swing deviation dw of the incidence surface concentrated light beam region FLRd on the opposite side with respect to the directly opposite state is 1 mm.

Accordingly, either when the concentrating solar power generation module 201 is past the sunlight Ls, or when the sunlight Ls is past the concentrating solar power generation module 201, the swing deviation dw of the incidence surface concentrated light beam region FLRd with respect to the directly opposite state at a maximum value of the swing angle can be made sufficiently small relative to the size of the incidence surface 231, so that the light-concentrating characteristics will not fluctuate, and the light-concentrating efficiency will not be reduced, even if an intentional positional shift operation by sun-tracking control (swing control) is performed.

The tilting angle during the tilting drive can be ±0.025 degrees at a maximum, and the tilt deviation can be 0.5 mm. That is, the tilt deviation of the incidence surface concentrated light beam region FLRd with respect to the directly opposite state at a maximum value of the tilting angle can be made sufficiently small relative to the size of the incidence surface 231, so that the light-concentrating efficiency will not be reduced even if an intentional positional shift operation by the sun-tracking control (tilting control) is performed.

As described above, the concentrating solar power generation module 201 according to this embodiment employs a configuration in which the incidence surface concentrated light beam region FLRd is located inside the incidence surface 231 in an intermittent sun-tracking control mode in which the position of the solar cell 210 (concentrating solar power generation module 201) is moved ahead of the sun toward a destination of the sun on the solar orbit at specific time intervals.

Accordingly, even if an intermittent sun-tracking control in which the position of the solar cell 210 is moved ahead of the sun toward a destination of the sun is employed, the fluctuation of the light-concentrating characteristics of the solar cell 210 can be suppressed to stabilize the light-concentrating efficiency, so that it is possible to stabilize the output characteristics of the solar cell 210, thus providing a highly reliable concentrating solar power generation module 201.

### Embodiment 5

A concentrating solar power generation module according to this embodiment will be described based on FIG. 5. The basic configuration of the concentrating solar power generation module according to this embodiment is the same as in Embodiments 1 to 4, and therefore a description will be given mainly for differences with reference to the reference numerals used in these embodiments.

FIG. 5 is an explanatory drawing conceptually illustrating the relationship between a set angle shift and an incidence surface concentrated light beam region formed on an incidence surface when an assembly error has occurred between a concentrating lens and a solar cell of a concentrating solar power generation module according to Embodiment 5 of the present invention.

The positional shift between an incidence surface concentrated light beam region FLRd formed on the incidence surface 231 and the center of the incidence surface 231 (optical axis Lax) occurs not only during operation as describe above, but also may occur as a result of an assembly error during a manufacturing process. That is, highly accurate parallelism is required between the solar cell 210 (solar cell element 211) and the concentrating lens 250. However, there are cases where the concentrating lens 250 may be assembled as a concentrating solar power generation module 201 in a state in which a set angle shift α occurs as a result of the concentrating lens 250 being shifted from the original parallel position relative to the solar cell 210.

When such an assembly error of the concentrating lens 250 with respect to the solar cell 210 occurs, the sunlight Ls concentrated by the concentrating lens 250 (concentrated light beam region FLR) undergoes positional shift with respect to the incidence surface 231. That is, with respect to the incidence surface concentrated light beam region FLRd with no positional shift, an incidence surface concentrated light beam region FLRds that has undergone positional shift in the lateral direction is formed on the incidence surface 231.

As described in Embodiment 4, when the length w of a side of the incidence surface 231 is 9.4 mm and the diameter of the incidence surface concentrated light beam region FLRd is 7 mm, the incidence surface concentrated light beam region FLRds that has undergone positional shift will be shifted by 1 mm at a maximum with respect to the original incidence surface concentrated light beam region FLRd if the maximum value of the set angle shift α is set to 0.1 degrees, for example. That is, even if the concentrating lens 250 has undergone positional shift in any direction, the incidence surface concentrated light beam region FLRds can be located inside the incidence surface 231. Accordingly, the light-concentrating efficiency will not be reduced, so that it is possible to provide a highly reliable concentrating solar power generation module 201 having improved light-concentrating efficiency and conversion efficiency.

### Embodiment 6

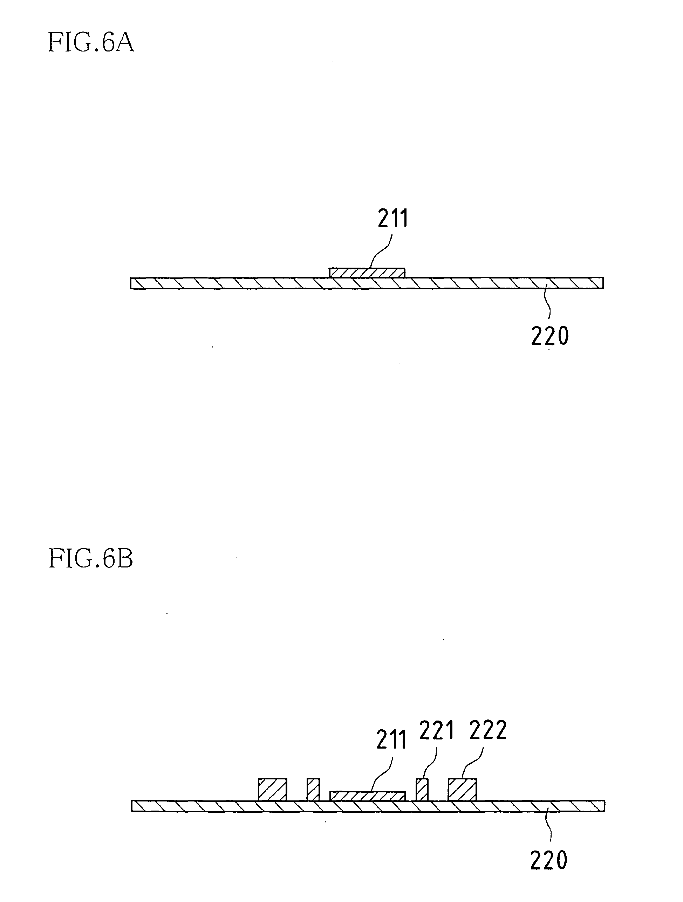

A solar cell manufacturing method according to this embodiment will be described based on FIGS. 6A to 6E. The basic configuration of the solar cell according to this embodiment is the same as in Embodiments 1 to 5, and therefore a description will be given mainly for differences with reference to the reference numerals used in these embodiments.

FIG. 6A is a process diagram showing a substrate preparation step of preparing a receiver substrate on which a solar cell is placed by a solar cell manufacturing method according to Embodiment 6 of the present invention.

FIG. 6B is a process diagram showing a resin stopper portion formation step of forming an inner resin stopper portion and an outer resin stopper portion by the solar cell manufacturing method according to Embodiment 6 of the present invention.

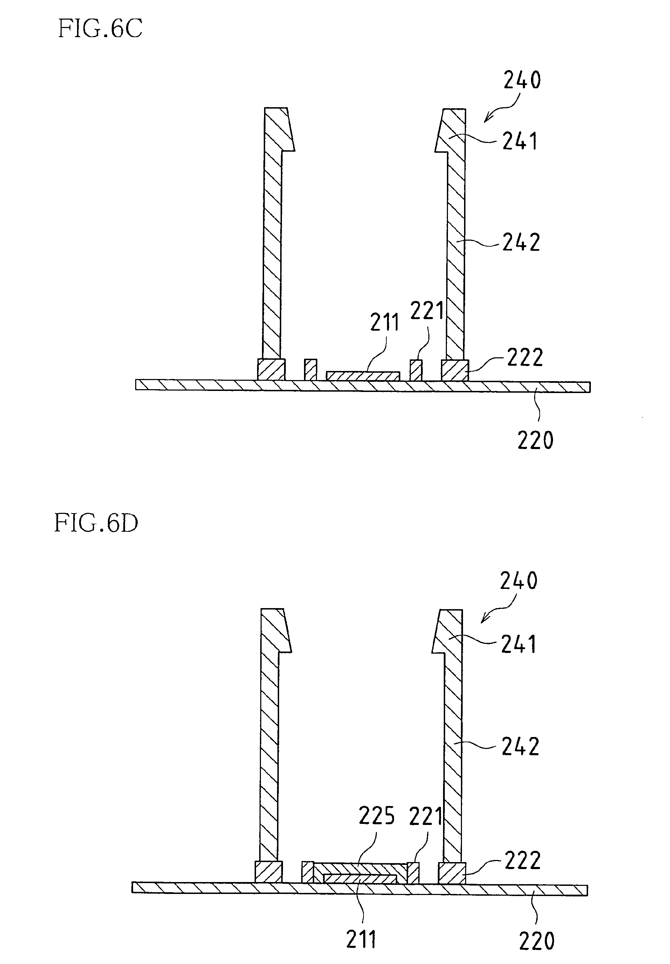

FIG. 6C is a process diagram showing a support fixation step of fixing a support of a holding portion to the receiver substrate by the solar cell manufacturing method according to Embodiment 6 of the present invention.

FIG. 6D is a process diagram showing a translucent resin injection step of injecting a translucent resin inside the inner resin stopper portion by the solar cell manufacturing method according to Embodiment 6 of the present invention.

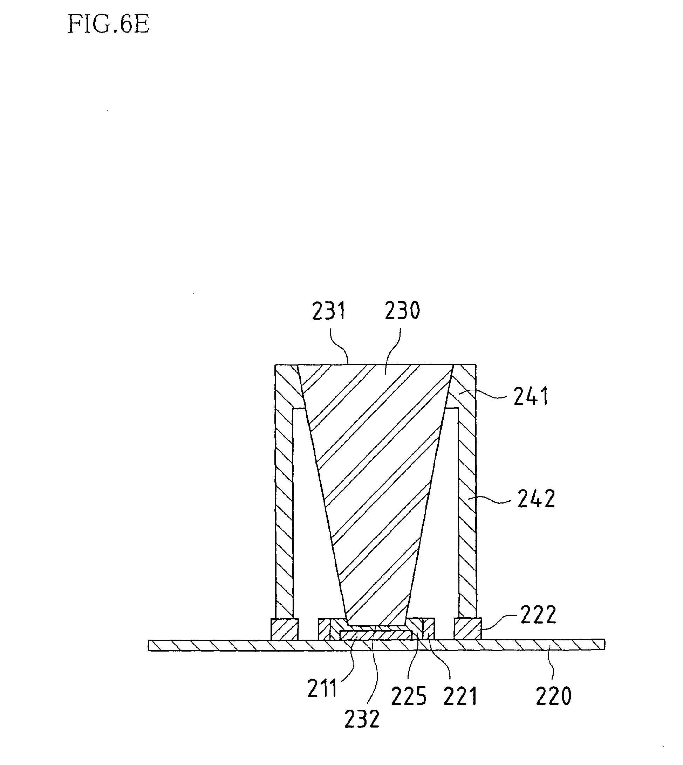

FIG. 6E is a process diagram showing a columnar optical member placement step of placing an irradiation surface on the translucent resin with the columnar optical member abutted against the holding portion by the solar cell manufacturing method according to Embodiment 6 of the present invention.

A solar cell manufacturing method according to this embodiment can manufacture a solar cell 210 including a solar cell element 211 that photoelectrically converts sunlight Ls concentrated by a concentrating lens 250, a receiver substrate 220 on which the solar cell element 211 is placed, a columnar optical member 230 having an incidence surface 231 on which the concentrated sunlight Ls is incident and an irradiation surface 232 that is disposed facing the solar cell element 211 and that irradiates the sunlight Ls to the solar cell element 211, and a holding portion 240 that is provided in a standing manner on the receiver substrate 220, the holding portion 240 including a frame-shaped abutting frame member 241 abutted against a side surface 233 of the columnar optical member 230 and a support 242 that is disposed away from the columnar optical member 230 and that supports the abutting frame member 241.

Further, the solar cell manufacturing method according to this embodiment includes a substrate preparation step, a resin stopper portion formation step, a support fixation step, a translucent resin injection step, a columnar optical member placement step, and a resin sealing portion formation step.

First, a receiver substrate 220 on which a solar cell element 211 is placed is prepared (the substrate preparation step; FIG. 6A).

Next, an adhesive resin is applied to the receiver substrate 220 to form an inner resin stopper portion 221 into which a translucent resin for sealing the solar cell element 211 with resin will be injected and an outer resin stopper portion 222 to which the support 242 will be fixed outside the inner resin stopper portion 221 (the resin stopper portion formation step; FIG. 6B).

Since a translucent resin for sealing the solar cell element 211 with resin is injected inside the inner resin stopper portion 221 in a later step, the inner resin stopper portion 221 is formed around the solar cell element 211 in the shape of a ring (in the shape of a picture frame). Since the support 242 is fixed by bonding to the outer resin stopper portion 222 in a later step, the outer resin stopper portion 222 is formed only at a position corresponding to the support 242.

Note that the outer resin stopper portion 222 may be formed around the inner resin stopper portion 221 in the shape of a ring (in the shape of a picture frame), thus preventing the translucent resin injected inside the inner resin stopper portion 221 from expanding from the inner resin stopper portion 221 more than necessary. When the outer resin stopper portion 222 is formed in the shape of a ring, this produces the action of blocking moisture infiltrating along the surface of the receiver substrate 220.

The support 242 is fixed to the receiver substrate 220 by bonding the support 242 to the outer resin stopper portion 222 and curing the adhesive resin (the support fixation step; FIG. 6C). The outer resin stopper portion 222 can be cured by performing a heat treatment at a temperature at which the adhesive resin forming the outer resin stopper portion 222 is cured. In addition, curing for the inner resin stopper portion 221 is also performed along with curing for the outer resin stopper portion 222.

A translucent resin is injected inside the inner resin stopper portion 221 (the translucent resin injection step; FIG. 6D). As the translucent resin, it is possible to use epoxy resin, silicone resin, and the like, as described above.

After the translucent resin has been injected inside the inner resin stopper portion 221, the irradiation surface 232 is placed on the translucent resin with the columnar optical member 230 abutted against the abutting frame member 241 (the columnar optical member placement step; FIG. 6E).

The translucent resin is cured to form a resin sealing portion 225 (the resin sealing portion formation step; not shown). By heating the translucent resin to an appropriate temperature, it is possible to perform defoaming simultaneously with curing, thus forming a resin sealing portion 225 having excellent translucency

Since the irradiation surface 232 is placed on and brought into contact with the translucent resin, the irradiation surface 232 is bonded by the translucent resin of the resin sealing portion 225, and the columnar optical member 230 is fixed to the solar cell element 211 with reliability and high accuracy. Note that it is possible to ensure a greater mechanical strength by injecting an adhesive resin into groove portions 241g, and bonding and fixing the columnar optical member 230 and the holding portion 240 to each other at the groove portions 241g.

With the solar cell manufacturing method according to this embodiment, it is possible to manufacture, with high productivity (that is, with ease and high accuracy) and low cost, a highly heat-resistant and reliable solar cell 210 having improved light-concentrating efficiency and photoelectric conversion efficiency by preventing fluctuation of the light-concentrating characteristics by allowing the incidence surface concentrated light beam region FLRd to be located within the region of the incidence surface 231 when the concentrated sunlight Ls (concentrated light beam region FLR) has undergone positional shift with respect to the center of the columnar optical member 230, and dispersing, with the abutting frame member 241, the heat applied by the concentrated sunlight Ls to the columnar optical member 230.

### Embodiment 7

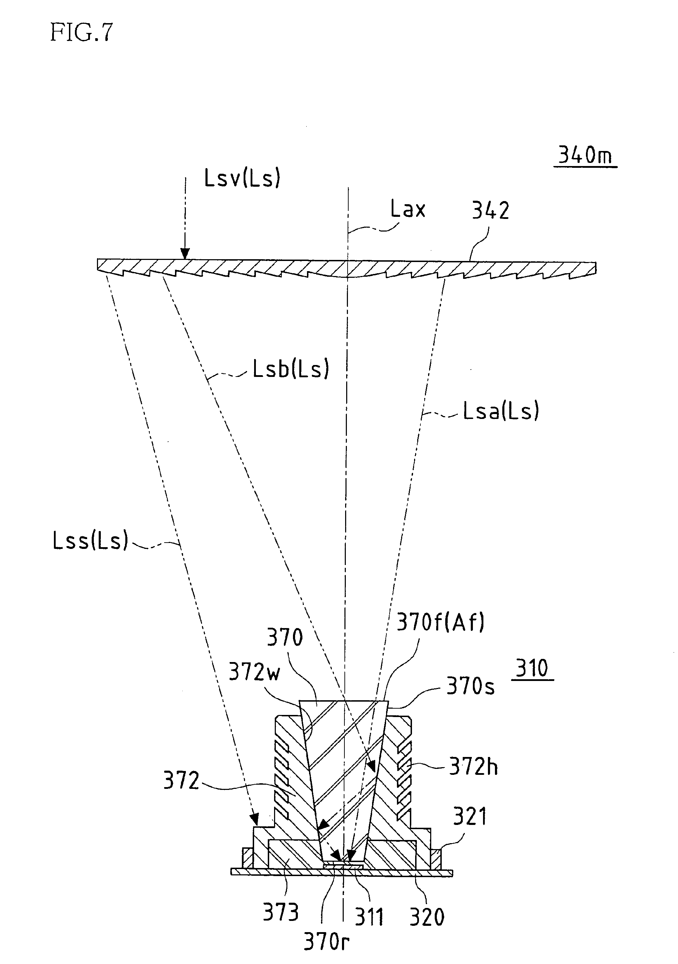

A solar cell and a concentrating solar power generation module according to this embodiment will be described based on FIGS. 7 to 9.

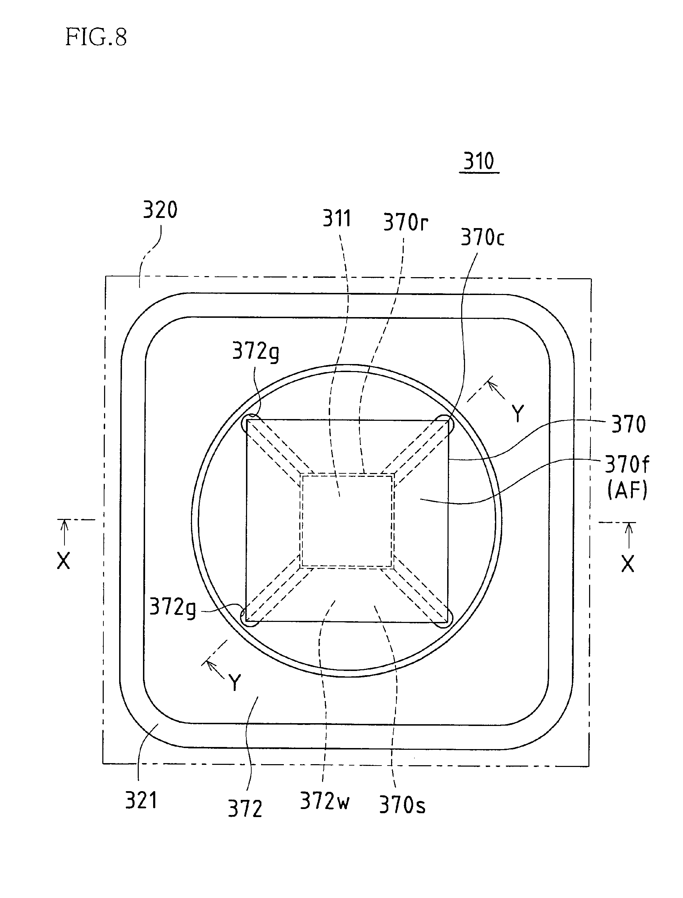

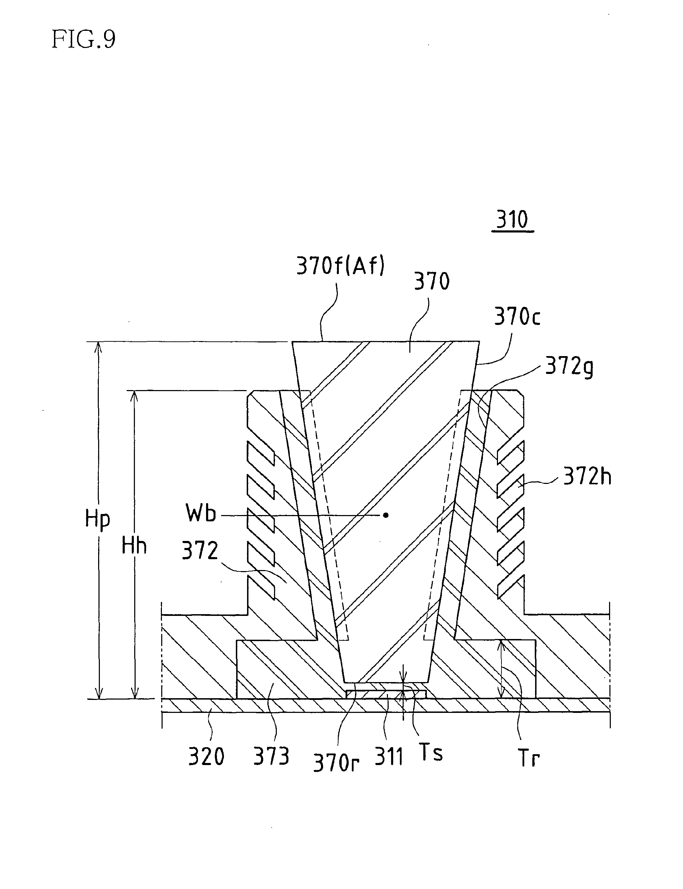

FIG. 7 is a cross-sectional view showing a solar cell and a concentrating solar power generation module according to Embodiment 7 of the present invention. FIG. 8 is an enlarged plan view showing a state in which the solar cell shown in FIG. 7 is viewed in enlargement from the concentrating lens side. FIG. 9 is an enlarged cross-sectional view showing a cross section as viewed in the direction of arrows Y-Y in FIG. 8. Note that the cross-sectional view of the solar cell show in FIG. 7 shows a cross section as viewed in the direction of arrows X-X shown in FIG. 8.

A solar cell 310 according to this embodiment includes a solar cell element 311 that photoelectrically converts the sunlight Ls (sunlight Lsa, sunlight Lsb) concentrated by a concentrating lens 342, a receiver substrate 320 on which the solar cell element 311 is placed, and a resin sealing portion 373 for sealing the solar cell element 311 with resin.

Note that the sunlight Lsa is sunlight that is normally concentrated by the concentrating lens 342, and is directly incident on the solar cell element 311. The sunlight Lsb is sunlight that has been concentrated by the concentrating lens 342, but could not be directly incident on the solar cell element 311 because of influences, for example, by an end portion of the lens and the wavelength range (especially, the short wavelength range) and has been concentrated to an incidence surface 370f (light-concentrating region Af) of a columnar optical member 370, as a result of which the sunlight travels through a light-guiding path (the columnar optical member 370) while being reflected inside the light-guiding path, and is irradiated to the solar cell element 311. That is, the sunlight Lsb is sunlight that would have been lost according to a conventional art (see FIG. 13).

Further, the solar cell 310 includes a columnar optical member 370 forming a light-guiding path for guiding the concentrated sunlight Ls to the solar cell element 311, and an optical holding portion 372 that has a holding wall 372w for holding the columnar optical member 370 and that is placed on the receiver substrate 320 so as to cover the resin sealing portion 373.

This makes it possible to secure a light-guiding path (columnar optical member 370) having high positional accuracy and stability and achieve light-concentrating characteristics by which the sunlight Ls can be concentrated highly accurately over a large wavelength range, so that it is possible to provide a highly heat-resistant, reliable and weather-resistant solar cell 310 having improved light-concentrating characteristics and heat dissipation that provides improved power generation efficiency and power generation by preventing a reduction in power generation efficiency and a temperature increase resulting from positional shift of the concentrated sunlight Ls.

In the receiver substrate 320, desired wiring (a connection pattern connected to an electrode (not shown) of the solar cell element 311 for extracting electric power to the outside; a connection pattern for connecting solar cells 310 to each other in series or in parallel; (not shown)) is formed, for example, on a metal base such as an aluminum plate or a copper plate via a suitable insulating layer.

That is, in this configuration, the electric current generated by the solar cell element 311 is extracted via the wiring formed in the receiver substrate 320 to the outside of the solar cell 310, as needed. Since it is necessary for the wiring formed in the receiver substrate 320 to ensure highly reliable insulation, the wiring is provided with insulation by covering, for example, a connection pattern formed of copper foil with an insulating film of an organic material or the like.

The columnar optical member 370 has an inclined optical path surface 370s for concentrating the sunlight Ls to the solar cell element 311, and the holding wall 372w is configured as an inclined holding surface in conformity with the inclined optical path surface 370s.

This makes it possible to self-align the columnar optical member 370 with the optical holding portion 372 and allow the columnar optical member 370 to be held by the holding wall 372w with high accuracy, so that it is possible to position the light-guiding path (columnar optical member 370) with high accuracy, thus improving the light-concentrating characteristics.

The columnar optical member 370 is formed, for example, of a heat-resistant glass, and has a refractive index of approximately 1.5, for example. The incidence surface 370f (light-concentrating region Af) of the columnar optical member 370 where the sunlight Ls is concentrated is configured to have an area of a size capable of allowing incidence of sunlight of approximately 400 nm, which is short wavelength light that is refracted the most of the sunlight Lsb refracted by an end portion of the concentrating lens 342.

Further, an irradiation surface 370r of the light-guiding path (columnar optical member 370) through which the sunlight Ls is irradiated to the solar cell element 311 is formed of a size that is about the same as that of the effective light-receiving surface region of the solar cell element 311 so that irradiation of the solar cell element 311 can be performed efficiently. Accordingly, the columnar optical member 370 has an inclined optical path surface 370s that is tapered from the incidence surface 370f to the irradiation surface 370r.

The angle of the optical holding portion 372 (holding wall 372w) relative to the receiver substrate 320 is set to 45° or more, enabling the incident sunlight Lsb to be totally reflected and irradiated to the solar cell element 311. Further, the height HP of the columnar optical member 370 from the receiver substrate 320 can be determined according to the angle of the inclined surface of the optical holding portion 372, the size of area of the irradiation surface 370r corresponding to the area (effective light-receiving surface region) of the solar cell element 311, and the size of the incidence surface 370f of the columnar optical member 370.

Therefore, the size of the columnar optical member 370 can be appropriately determined according to the area of incidence surface 370f that allows incidence of the sunlight Ls without loss, the angle, from the receiver substrate 320, of the holding wall 372w (inclined holding surface) of the optical holding portion 372 at which the sunlight Ls is totally reflected and irradiated to the solar cell element 311, and the area of the irradiation surface 370r.

When the total reflection at the columnar optical member 370 cannot be utilized because of the relationship relative to the optical holding portion 372, a reflection surface formed, for example, by vacuum evaporation, sputtering of a metal film of Al, Ag, Ni, or the like may be formed on the inclined optical path surface 370s of the columnar optical member 370.

As described above, with the columnar optical member 370 according to this embodiment, it is possible to allow the sunlight Lsa that has been normally concentrated by the concentrating lens 342 to be directly incident on the solar cell element 311, and allow the sunlight Lsb that has been concentrated by the concentrating lens 342 to the incidence surface 370f to travel through the light-guiding path (columnar optical member 370) while being subjected to multiple reflection, and to be incident on the solar cell element 311, and therefore, it is possible to increase the power generation efficiency of the solar cell 310.

Further, the optical holding portion 372 is abutted against a metal base (not shown) of the receiver substrate 320, and bonded by the adhesive portion 321 to the receiver substrate 320. That is, the optical holding portion 372 is directly bonded to the receiver substrate 320 (base) in a state in which an appropriate contact area is secured.

Accordingly, the heat generated on the receiver substrate 320 (solar cell element 311) resulting from the concentrated sunlight Ls can be efficiently conducted to the optical holding portion 372 formed of metal, and the heat conducted to the optical holding portion 372 can be effectively dissipated by a fin 372h that increases the heat dissipation area, so that it is possible to efficiently dissipate the heat resulting from the sunlight Ls concentrated to the solar cell element 311, thus improving power generation efficiency and reliability of the solar cell 310.

In addition, it is preferable that the optical holding portion 372 is formed, for example, of metal. Forming the optical holding portion 372 of metal makes it possible to form an optical holding portion 372 having excellent heat dissipation easily and with low cost and good productivity

The optical holding portion 372 includes a comb tooth-shaped fin 372h, for example, on its outer peripheral side surface. Accordingly, it is possible to further improve the heat dissipation characteristics, thus further improving the power generation efficiency and reliability. In addition, the fin 372h is formed in a shape having a slope extending from its basal portion to its tip in a direction away from the receiver substrate 320 (upward), and the heat dissipation has been further improved.

The columnar optical member 370 is configured as a quadrangular prism, and the optical holding portion 372 includes groove-shaped notch portions 372g respectively surrounding axial corner portions 370c of the quadrangular prism. Accordingly, it is possible to prevent the columnar optical member 370 from being damaged at the axial corner portions 370c by the optical holding portion 372, and place the columnar optical member 370 with respect to the optical holding portion 372 reliably and highly accurately.

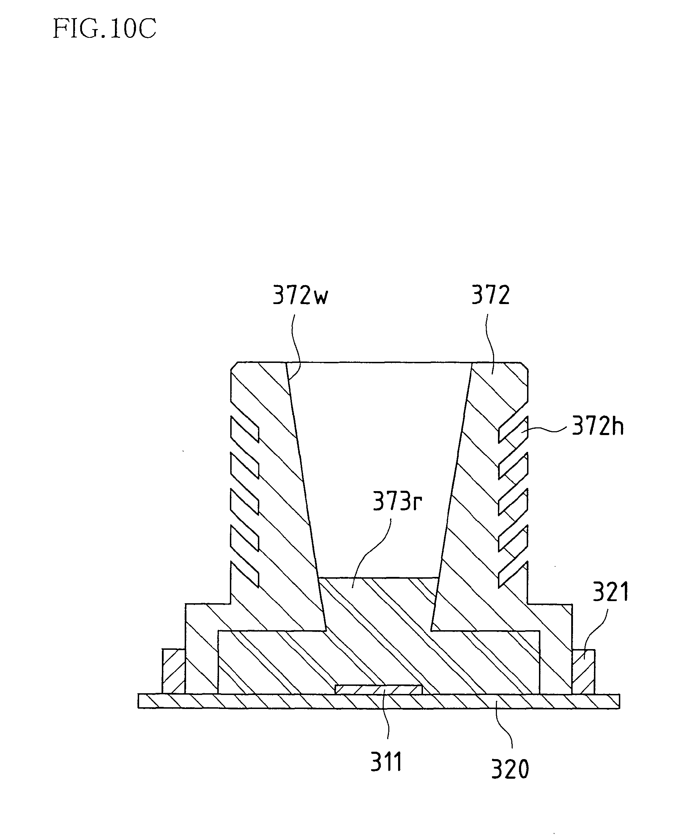

Since the notch portions 372g enable reliable defoaming and filling of the sealing resin 373r (see FIG. 10C) filled between the columnar optical member 370 and the optical holding portion 372, it is possible to define (position) the light-guiding path (columnar optical member 370) highly accurately, thus providing a high-quality light-guiding path that prevents entry of bubbles between the inclined optical path surface 370s and the holding wall 372w, or in the resin sealing portion 373.

In addition, it is preferable that the optical holding portion 372 is formed such that the height Hh from the receiver substrate 320 is greater than the position of the center of gravity Wb of the columnar optical member 370. This configuration enables the center of gravity of the columnar optical member 370 to be stably and reliably held by the optical holding portion 372. Accordingly, it is possible to prevent the columnar optical member 370 from rocking or falling over by the optical holding portion 372 and suppress rocking of the concentrated sunlight Ls to perform highly reliable power generation, thus improving the reliability of the solar cell 310.

Furthermore, interposing the sealing resin 373r allows the columnar optical member 370 to be in close contact with the optical holding portion 372, and thus enables stable placement of the columnar optical member 370 with respect to the optical holding portion 372, thus improving the productivity.

The resin sealing portion 373 is formed by an insulating sealing resin 373r filled between the solar cell element 311 and the optical holding portion 372, and is configured, by using, for example, transparent silicone resin, such that sunlight Ls that has been transmitted through the columnar optical member 370 can be irradiated to the solar cell element 311.

The thickness of the resin sealing portion 373 is configured to be smaller between the columnar optical member 370 and the solar cell element 311 than in the surrounding region thereof. In other words, the resin sealing portion 373 is formed such that the thickness Tr in the surrounding region is thicker than the thickness Ts between the columnar optical member 370 and the solar cell element 311.

Accordingly, the surface (irradiation surface 370r) of the columnar optical member 370 that faces the solar cell element 311 can be reliably positioned adjacent to the solar cell element 311 (effective light-receiving surface region), so that it is possible to effectively irradiate the sunlight Ls concentrated by the columnar optical member 370 to the solar cell element 311.

Furthermore, since it is possible to suppress the temperature increase of the receiver substrate 320 in the region surrounding the solar cell element 311, it is possible to increase the heat resistance, thus providing a highly reliable and weather-resistant solar cell 310.

Although the sunlight Ls is concentrated to the solar cell element 311 by a sun-tracking mechanism in this configuration, there may be cases where the concentration spot is shifted as a result of positional shift caused, for example, by the occurrence of a sun-tracking error or an alignment error of the optical system. That is, there may be cases where the sunlight Lss that has undergone positional shift is irradiated to the solar cell 310. Note that in the following, the shift of the concentration spot resulting from a sun-tracking error, alignment error, variations in light intensity, or the like may be simply described as resulting from a sun-tracking error (tracking error or the like).

Since the optical holding portion 372 is disposed outside the light-concentrating region Af (columnar optical member 370) that is set for the sunlight Ls (sunlight Lsa, sunlight Lsb) that has been concentrated toward the solar cell element 311 (effective light-receiving surface region), the sunlight Lss can be reflected if sunlight Lss is generated.

Accordingly, even if the concentrated sunlight Ls has undergone positional shift, for example, due to a sun-tracking error and the sunlight Lss is thus irradiated to a position shifted from the position of the solar cell element 311 (effective light-receiving surface region), it is possible to prevent the sunlight Lss from being irradiated to the receiver substrate 320.

Since the wiring formed on the surface of the receiver substrate 320 is formed of an organic member having low heat resistance as described above, there is the possibility of damage being caused to the organic member and hence the wiring in the case where sunlight Lss is irradiated, and that the reliability of the solar cell 310 may be reduced. However, the portion of the receiver substrate 320 around the solar cell element 311 is covered with the optical holding portion 372 (and the resin sealing portion 373), and it is therefore possible to prevent the sunlight Lss from being directly applied to the receiver substrate 320 (wiring), thus preventing damage to the wiring and the like. Accordingly, it is possible to suppress the temperature increase of the surface of the receiver substrate 320, thereby preventing the members (the wiring, the insulating film, and so forth) disposed on the surface of the receiver substrate 320 from suffering from fire damage.

That is, by disposing the optical holding portion 372 on the receiver substrate 320 in the outer peripheral region of the solar cell element 311, it is possible to prevent the wiring (organic member) and the like of the receiver substrate 320 from being burnt even for a high concentration magnification greater than or equal to 600 SUN (1 SUN = 100 mW/cm²), for example, and it is therefore possible to provide a solar cell 310 having improved heat resistance and high reliability and weather resistance with good efficiency and low cost.

Furthermore, forming the optical holding portion 372, for example, of metal as described above enables the sunlight Lss to be reflected effectively.

The solar cell element 311 is formed, for example, of an inorganic material such as Si, GaAs, CuInGaSe, or CdTe. As the structure of the solar cell element 311, it is possible to use a variety of forms of structures such as a single-junction solar cell element, a monolithic multi-junction solar cell element, and a mechanical stack solar cell structure in which various solar cell elements with different wavelength sensitivity ranges are connected.

In addition, the outside dimension of the solar cell element 311 is preferably from approximately several mm to 20 mm, from the viewpoint of reduction of the material of a solar cell used, low processing cost, ease and simplification of the process, and the like.

In order to reduce the light reflectance in the sensitivity wavelength range of the solar cell element 311, an appropriate anti-reflection film, or the like may be formed on the surface of the solar cell element 311. Furthermore, it is possible to form a UV reflecting film, an infrared reflecting film, or the like that reflects sunlight having a wavelength other than the sensitivity wavelength range of the solar cell element 311.

A concentrating solar power generation module 340m according to this embodiment includes a concentrating lens 342 that concentrates sunlight Ls (sunlight Lsv), and a solar cell 310 (solar cell element 311) that photoelectrically converts sunlight Ls (sunlight Lsa, sunlight Lsb) concentrated by the concentrating lens 342.

The concentrating lens 342 is configured to be directly opposite the sun by the action of a sun-tracking mechanism (not shown). Accordingly, sunlight Lsv is incident perpendicularly on the incidence surface of the concentrating lens 342. The concentrating lens 342 is also configured to refract the sunlight Lsv and concentrate it to the solar cell element 311 (in this embodiment, the incidence surface 370f serving as a light-concentrating region Af).

With the solar cell 310, it is possible to secure a light-guiding path (columnar optical member 370) having high positional accuracy and stability to obtain light-concentrating characteristics capable of highly accurately concentrating sunlight Ls in a wide wavelength range including wavelengths in a short-wavelength range, and it is therefore possible to improve the light-concentrating characteristics, and prevent reduction of the power generation efficiency and the temperature increase that result from positional shift of the concentrated sunlight Ls, thus improving the heat resistance. Accordingly, it is possible to provide a highly reliable and weather-resistant concentrating solar power generation module 340m that provides improved power generation efficiency and power generation.

In addition, for the solar cell element 311 used for the concentrating solar power generation module 340m, it is preferable to use a triple-junction solar cell element formed of InGaP/GaAs/Ge, a solar cell element formed of AlGaAs/Si, or a monolithic multi-junction solar cell element, since high efficiency and practicality are particularly required.

In order to perform effective concentration with the concentrating lens 342, the surface of the solar cell element 311 that photoelectrically converts the sunlight Ls is flat, and is disposed parallel to the incidence surface of the concentrating lens 342, and the incidence surface 370f and the irradiation surface 370r of the columnar optical member 370.

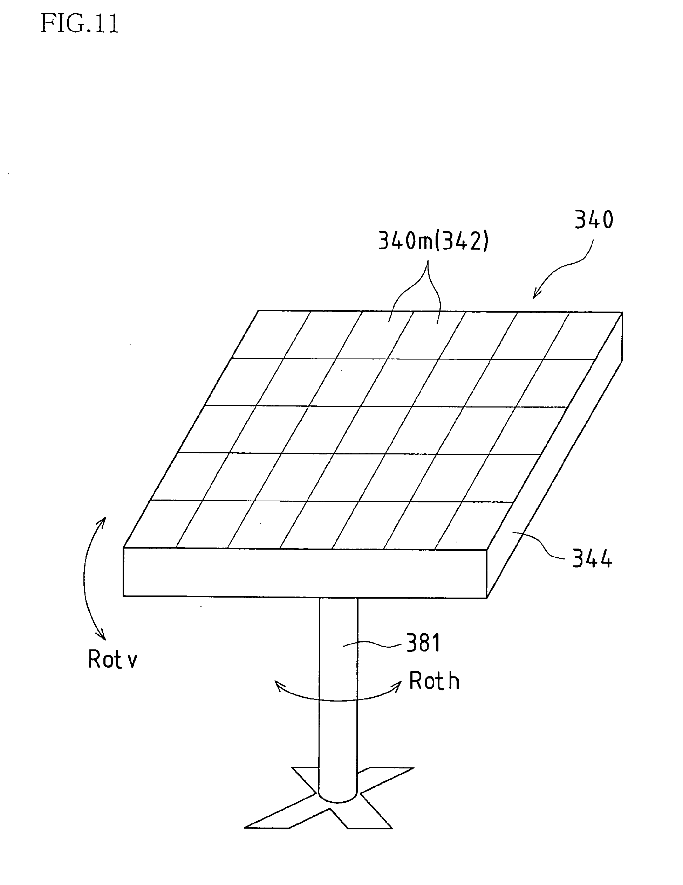

Examples of the concentrating lens 342 include a double-convex lens, a plano-convex lens, and a Fresnel lens. From the viewpoint of the weight, cost, ease of handling in the usage environment, and so forth, it is preferable that the incidence surface for receiving the sunlight Ls is configured to be flat, and the exit surface for irradiating the sunlight Ls to the solar cell element 311 is configured in the shape of a Fresnel lens having a substantially triangular cross section. Note that the concentrating lens 342 may be configured in an array configuration (see FIG. 11) in which a plurality of the same optical system are arranged and integrated.

The material of the concentrating lens 342 preferably has a high transmittance for sensitivity wavelength light of the solar cell element 311 and weather resistance. For example, it is possible to use thin sheet glass, weather-resistant grade acrylic, polycarbonate, and the like that are commonly used for an ordinary solar cell module (solar power generation system) and the like. Note that the material of the concentrating lens 342 is not limited to these materials, and a material formed by a plurality of layers of these materials may also be used. Further, a suitable ultraviolet absorber may be added to these materials for the purpose of preventing ultraviolet degradation of the concentrating lens 342 itself or the other members.

### Embodiment 8

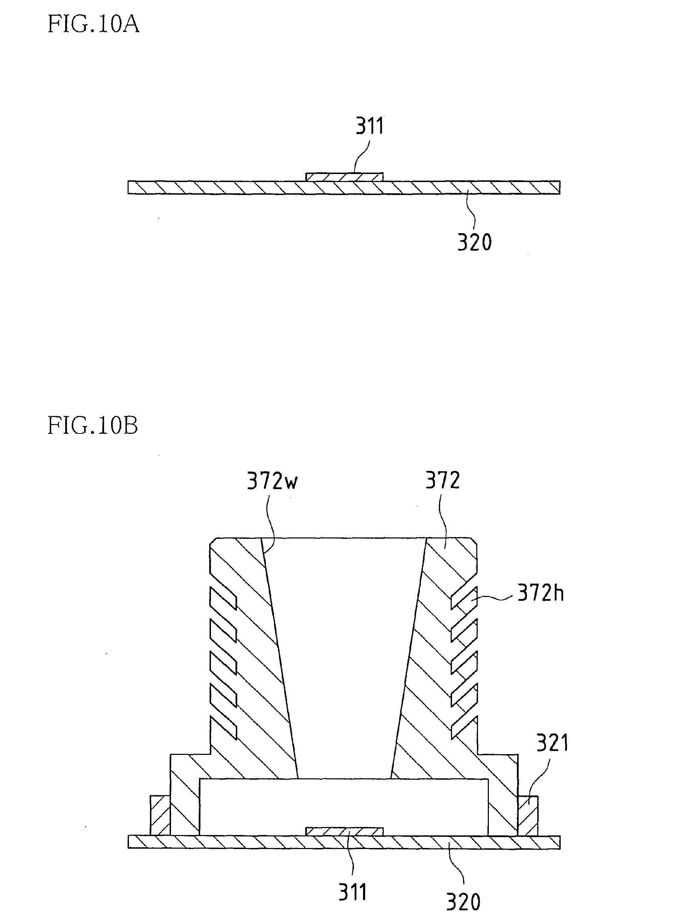

A solar cell manufacturing method according to this embodiment will be described based on FIGS. 10A to 10D. Note that a solar cell that is manufactured by the solar cell manufacturing method according to this embodiment is a solar cell 310 according to Embodiment 7, and therefore the reference numerals used in Embodiment 7 are used as they are.

Separately from the step (solar cell element mounting step) shown in FIG. 10A, the optical holding portion 372 is first prepared by shaping a metal (optical holding portion preparation step). Note that the shape of the optical holding portion 372 is as described in Embodiment 7, and the description thereof has therefore been omitted where appropriate.

That is, a holding wall 372w (inclined holding surface) having an angle of inclination identical to that of an inclined optical path surface 370s of the columnar optical member 370 is formed inside a metal block in correspondence with the inclined optical path surface 370s. Further, notch portions 372g are formed in correspondence with the axial corner portions 370c of the columnar optical member 370. Along with this, a space covering the resin sealing portion 373 is formed adjacent to a surface abutting against the receiver substrate 320. Also, a fin 372h is formed on the outer periphery of the optical holding portion 372.

Here, as the method for producing the optical holding portion 372, die casting capable of high precision processing or a method in which a metal block is cut to produce the optical holding portion 372 may be used.

FIG. 10A is a process diagram illustrating a solar cell manufacturing method according to Embodiment 8 of the present invention, showing a state in which a solar cell element is placed on a receiver substrate in a cross section as viewed in the direction of arrows X-X in FIG. 8.

Separately from the optical holding portion preparation step, the solar cell element 311 is mounted on the receiver substrate 320 (solar cell element mounting step).

FIG. 10B is a process diagram illustrating the solar cell manufacturing method according to Embodiment 8 of the present invention, showing a state in which an optical holding portion is placed on a receiver substrate in a cross section as viewed in the direction of arrows X-X in FIG. 8.

After the solar cell element 311 has been mounted on the receiver substrate 320, an adhesive portion 321 is formed on the receiver substrate 320 in correspondence with the position at which the optical holding portion 372 is disposed on the outer periphery of the solar cell element 311 (adhesive portion formation step). For example, a metal frame or a plastic frame may be formed and disposed as the adhesive portion 321, but it is preferable that resin or an adhesive capable of bonding the optical holding portion 372 is appropriately disposed as the adhesive portion 321.

The adhesive portion 321 is disposed so as to bond the optical holding portion 372 to the receiver substrate 320 on the side surface of the optical holding portion 372 such that the optical holding portion 372 can be directly abutted against the base (not shown) of the receiver substrate 320. Here, when a highly heat conductive adhesive is used, the adhesive portion 321 may be interposed between the receiver substrate 320 and the optical holding portion 372.

After the adhesive portion 321 has been formed, the optical holding portion 372 is aligned with the adhesive portion 321, and is disposed abutting against the receiver substrate 320 (optical holding portion placement step). At this time, the optical holding portion 372 is disposed such that the central portion of the optical holding portion 372 that is constituted by the holding wall 372w (corresponding to the central position of the irradiation surface 370r) coincides with the center of the solar cell element 311 (effective light-receiving surface region).

FIG. 10C is a process diagram illustrating the solar cell manufacturing method according to Embodiment 8 of the present invention, showing a state in which a sealing resin has been injected into the space that the optical holding portion forms between the receiver substrate in a cross section as viewed in the direction of arrows X-X in FIG. 8.

A sealing resin 373r for protecting the solar cell element 311 is injected, via the space formed by the holding wall 372w, into the space (the space forming the resin sealing portion 373 and a portion of the space in which the columnar optical member 370 is disposed) formed by the optical holding portion 372 and the receiver substrate 320 (resin injection step).

The amount of the sealing resin 373r injected may be such an amount that the sealing resin 373r can fill the gap between the columnar optical member 370 and the optical holding portion 372 when the columnar optical member 370 is placed and will not leak from the optical holding portion 372 (notch portions 372g), and a predetermined appropriate amount of the sealing resin 373r is injected.

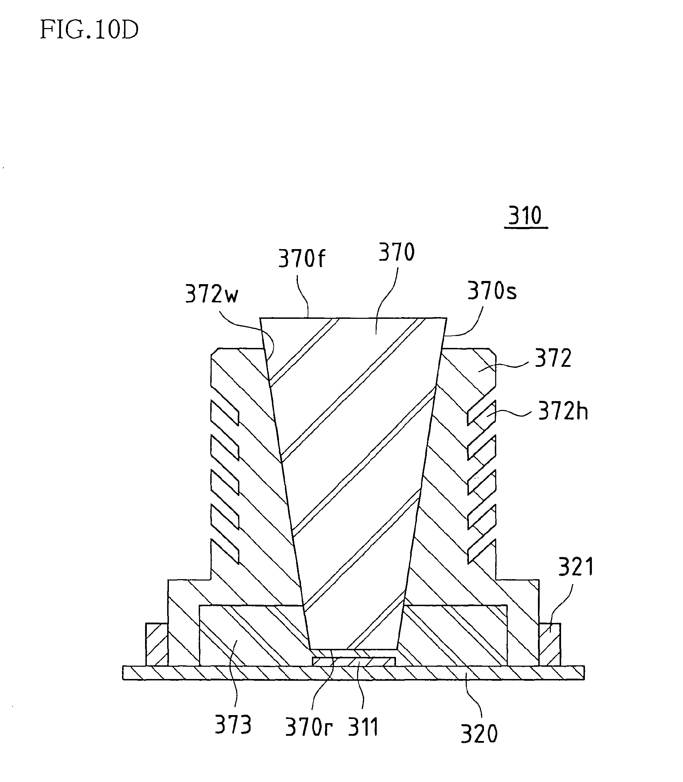

FIG. 10D is a process diagram illustrating the solar cell manufacturing method according to Embodiment 8 of the present invention, showing a state in which a columnar optical member is placed on the optical holding portion in a cross section as viewed in the direction of arrows X-X in FIG. 8.

Before the injected sealing resin 373r has been cured, the columnar optical member 370 is place on the optical holding portion 372 (holding wall 372w) (optical member placement step), and is housed in a vacuum chamber for defoaming (bubble defoaming step). Since the notch portions 372g formed in the optical holding portion 372 serve as an exhaust passage of bubbles, it is possible to perform reliable defoaming by a simple process.

Defoaming performed in the bubble defoaming step causes a reduction in the pressure of the sealing resin 373r, so that the columnar optical member 370 is pressed against the holding wall 372w by its own weight and moved so as to be highly accurately inserted toward the solar cell element 311 in a self-aligned manner. Further, since the sealing resin 373r is filled between the columnar optical member 370 and the optical holding portion 372 and serves as a lubricant, it is possible to protect the surface of the columnar optical member 370 by reducing the frictional resistance between the columnar optical member 370 and the optical holding portion 372, and place (couple) the columnar optical member 370 onto the optical holding portion 372 more smoothly.

After the bubble defoaming step, the sealing resin 373r is cured to form a resin sealing portion 373, and the columnar optical member 370 and the optical holding portion 372 are fixed in close contact with each other (resin curing step/columnar optical member fixation step).

As described above, the solar cell manufacturing method according to this embodiment relates to a solar cell manufacturing method for manufacturing a solar cell 310 including a solar cell element 311 that photoelectrically converts sunlight Ls concentrated by a concentrating lens 342, a receiver substrate 320 on which the solar cell element 311 is placed, a resin sealing portion 373 for sealing the solar cell element 311 with resin, a columnar optical member 370 constituting a light-guiding path for guiding the concentrated sunlight Ls to the solar cell element 311, and an optical holding portion 372 that includes a holding wall 372w for holding the columnar optical member 370 and that is placed on the receiver substrate 320 so as to cover the resin sealing portion 373.

Furthermore, the solar cell manufacturing method according to this embodiment includes an optical holding portion preparation step of preparing the optical holding portion 372 by forming metal; an optical holding portion placement step of placing the optical holding portion 372 so as to abut against the receiver substrate 320 on the outer periphery of the solar cell element 311; a resin injection step of injecting a sealing resin 373r for forming the resin sealing portion 373 into a space formed by the optical holding portion 372 and the receiver substrate 320; and an optical member placement step of placing the columnar optical member 370 on the holding wall 372w.

This makes it possible to align the optical holding portion 372 with the columnar optical member 370 highly accurately by a simple process, and the light-guiding path (columnar optical member 370) for effectively guiding the sunlight Ls with high accuracy and the optical holding portion 372 can be formed easily, so that it is possible to manufacture, with good productivity and low cost, a highly heat-resistant, reliable and weather-resistant solar cell 310 having improved light-concentrating characteristics and heat dissipation that provides improved power generation efficiency and power generation by preventing a reduction in power generation efficiency and a temperature increase resulting from positional shift of the concentrated sunlight Ls.

### Embodiment 9

A concentrating solar power generation unit according to this embodiment will be described based on FIG. 11. Note that the concentrating solar power generation unit according to this embodiment is formed by placing a plurality of concentrating solar power generation modules 340m each including the solar cell 310 described in Embodiment 7, and the reference numeral used in Embodiment 7 will therefore be used as they are.

FIG. 11 is an oblique view schematically showing a configuration of a concentrating solar power generation unit according to Embodiment 9 of the present invention.

A concentrating solar power generation unit 340 according to this embodiment includes an elongated frame 344 and a plurality of concentrating solar power generation modules 340m that are disposed along the elongated frame 344. Note that the concentrating solar power generation modules 340m may be independent from each other by being placed in individual frames separated from the elongated frame 344.

This makes it possible to secure a light-guiding path (columnar optical member 370) having high positional accuracy and stability and achieve light-concentrating characteristics by which sunlight Ls can be concentrated highly accurately over a large wavelength range including wavelengths in a short-wavelength range, so that it is possible to provide a highly heat-resistant, reliable and weather-resistant concentrating solar power generation unit 340 having improved light-concentrating characteristics and heat dissipation that provides improved power generation efficiency and power generation by preventing a reduction in power generation efficiency and a temperature increase resulting from positional shift of the concentrated sunlight Ls.

The concentrating solar power generation modules 340m include, for example, an approximately 30 cm-square concentrating lens 342, and the concentrating solar power generation unit 340 can be configured to include, for example, 5 × 1 (5) concentrating solar power generation modules 340m. In this case, the concentrating solar power generation unit 340 forms a light-receiving surface of approximately 30 cm × 150 cm, for example.

In order to generate the electric power needed, an appropriate number of concentrating solar power generation modules 340m are connected in series or in parallel. In this embodiment, seven concentrating solar power generation units 340 are arranged in parallel to form a concentrating solar power generation system (concentrating solar power generation apparatus).

The concentrating solar power generation system (concentrating solar power generation apparatus) configured from a plurality of concentrating solar power generation units 340 is supported by a column 381, and is configured so as to be automatically driven by a horizontal rotation Roth and a vertical rotation Rotv by a sun-tracking mechanism portion (not shown) so as to track the sun, and to cause the concentrating lens 342 (incidence surface) disposed on the surface of the concentrating solar power generation modules 340m to face toward a direction perpendicular to sunlight Lsv.

Accordingly, the concentrating solar power generation unit 340 of this embodiment is applicable to a concentrating solar power generation system with a high concentration magnification. That is, with the concentrating solar power generation modules 340m of the present invention, it is possible to form a highly efficient and inexpensive sun-tracking concentrating solar power generation system having high reliability and weather resistance.

Even if sun-tracking fails due to a sun tracking error or the like, the solar cells 310 will not suffer from fire damage, and it is therefore possible to provide a highly reliable sun-tracking concentrating solar power generation system.

The sun-tracking mechanism portion (sun-tracking driving system) is formed by a sun-tracking driving apparatus having two different axes: an azimuth axis for causing the concentrating lens 342 (incidence surface) to face toward the azimuth of the sun; and an inclining axis for inclining the concentrating lens 342 (incidence surface) according to the altitude of the sun, and therefore it is possible to track the sun with high accuracy.

As the power system of the sun-tracking driving system, there are methods such as a method of driving the sun-tracking driving system in a specific direction by rotating a gear a predetermined number of times using a motor and a decelerator, and a method of driving the sun-tracking driving system in a specific direction by adjusting a cylinder to a predetermined length using a hydraulic pump and a hydraulic cylinder. Either method can be used.

As the sunlight-tracking method, the following methods are known: a method in which the orbit of the sun is calculated in advance by a clock that controls the operation of the sun-tracking driving system and that is included inside the sun-tracking driving system, and control is exerted so as to move the concentrating solar power generation modules 340m (concentrating solar power generation units 340) to face the orientation of the sun; and a method in which a solar sensor made of a photodiode or the like is attached to the sun-tracking driving system, and control is exerted so as to monitor the direction of the sun at any appropriate time. Either method can be used.

As described above, the concentrating solar power generation unit 340 according to this embodiment includes a plurality of concentrating solar power generation modules 340m that are disposed along the elongated frame 344. By including concentrating solar power generation modules 340m having improved light-concentrating characteristics and heat dissipation, a highly heat-resistant, reliable and weather-resistant concentrating solar power generation unit 340 having improved power generation efficiency and power generation is provided.

That is, it is possible to secure a light-guiding path having high positional accuracy and stability and achieve light-concentrating characteristics by which sunlight Ls can be concentrated highly accurately over a wide wavelength range, so that it is possible to provide a highly heat-resistant, reliable and weather-resistant concentrating solar power generation unit 340 having improved light-concentrating characteristics and heat dissipation that provides improved power generation efficiency and power generation by preventing a reduction in power generation efficiency and a temperature increase resulting from positional shift of the concentrated sunlight Ls.

The concentrating solar power generation unit 340 of the present invention includes an elongated frame 344, a plurality of concentrating solar power generation module 340m disposed along the elongated frame 344, so that it is possible to secure a light-guiding path having high positional accuracy and stability and achieve light-concentrating characteristics by which sunlight Ls can be concentrated highly accurately over a large wavelength range, so that it is possible to obtain an effect of improving the light-concentrating characteristics and the heat dissipation and increasing the power generation efficiency and the power generation by preventing a reduction in power generation efficiency and a temperature increase resulting from positional shift of the concentrated sunlight Ls, thus improving the heat-resistance, reliability and weather-resistance.

The present invention may be embodied in various other forms without departing from the gist or essential characteristics thereof. Therefore, the embodiments described above are to be considered in all respects as illustrative and not limiting. The scope of the invention is indicated by the appended claims rather than by the foregoing description, and all modifications or changes that come within the meaning and range of equivalency of the claims are intended to be embraced therein.

This application claims priority on Japanese Patent Application No. 2008-023021 filed in Japan on February 1, 2008 and Japanese Patent Application No. 2008-123938 filed in Japan on May 9, 2008, the entire content of which is incorporated herein by reference.

### Industrial Applicability

The present invention is applicable to a solar cell including a solar cell element that photoelectrically converts concentrated sunlight and a columnar optical member that irradiates the concentrated sunlight to the solar cell element, a concentrating solar power generation module including such a solar cell, and a solar cell manufacturing method for manufacturing such a solar cell.

## Claims

1. A solar cell comprising: a solar cell element that photoelectrically converts sunlight concentrated by a concentrating lens; a receiver substrate on which the solar cell element is placed; a columnar optical member having an incidence surface on which the concentrated sunlight is incident and an irradiation surface that is disposed facing the solar cell element and that irradiates sunlight to the solar cell element; and a holding portion that is provided in a standing manner on the receiver substrate and that holds the columnar optical member,
wherein the holding portion comprises a frame-shaped abutting frame member that is abutted against a side surface of the columnar optical member and that is configured to have a thickness in a direction from the incidence surface to the irradiation surface, and a support that is disposed away from the columnar optical member and that supports the abutting frame member,
the side surface is inclined such that incident sunlight is totally reflected in a direction of the irradiation surface, and
the incidence surface is configured of a size such that an incidence surface concentrated light beam region that is formed on the incidence surface by a concentrated light beam region formed by the concentrated sunlight is locatable inside the incidence surface.

2. The solar cell according to claim 1,
wherein the side surface has an angle of inclination of 8 to 20 degrees relative to a direction perpendicular to the irradiation surface.

3. The solar cell according to claim 1 or 2,
wherein the irradiation surface is configured of a size that is locatable inside the solar cell element.

4. The solar cell according to any one of claims 1 to 3,
wherein the abutting frame member is configured in a rectangular shape, and the support is disposed at four corners of the abutting frame member in a columnar manner.

5. A concentrating solar power generation module comprising: a concentrating lens that concentrates and causes sunlight to be incident on the solar cell; and a solar cell that photoelectrically converts the sunlight concentrated by the concentrating lens,
wherein the solar cell is the solar cell according to any one of claims 1 to 4.

6. The concentrating solar power generation module according to claim 5,
wherein a minimum concentrated light beam region where the concentrated light beam region is minimized is configured to be located inside the columnar optical member.

7. The concentrating solar power generation module according to claim 5 or 6,
wherein the abutting frame member is of a thickness that blocks an outer peripheral side region of a long-wavelength side concentrated light beam region formed by long-wavelength-side sunlight.

8. The concentrating solar power generation module according to claim 7,
wherein the minimum concentrated light beam region is configured to be located between a bottom portion of the abutting frame member and the irradiation surface.

9. The concentrating solar power generation module according to claim 8,
wherein a focal point group constituted by focal points of the concentrating lens that are displaced with a temperature change of the concentrating lens is located between the bottom portion and the irradiation surface.

10. The concentrating solar power generation module according to any one of claims 5 to 9,
wherein, in an intermittent sun-tracking control mode in which the position of the solar cell is moved ahead of the sun toward a destination of the sun on the solar orbit at specific time intervals, the incidence surface concentrated light beam region is located inside the incidence surface.

11. A solar cell manufacturing method for manufacturing a solar cell comprising: a solar cell element that photoelectrically converts sunlight concentrated by a concentrating lens; a receiver substrate on which the solar cell element is placed; a columnar optical member having an incidence surface on which the concentrated sunlight is incident and an irradiation surface that is disposed facing the solar cell element and that irradiates sunlight to the solar cell element; and a holding portion provided in a standing manner on the receiver substrate, the holding portion including a frame-shaped abutting frame member abutted against a side surface of the columnar optical member and a support that is disposed away from the columnar optical member and that supports the abutting frame member, the method comprising:
a substrate preparation step of preparing the receiver substrate on which the solar cell element is placed;
a resin stopper portion formation step of applying an adhesive resin to the receiver substrate to form an inner resin stopper portion into which a translucent resin for sealing the solar cell element with resin will be injected and an outer resin stopper portion to which the support will be fixed outside the inner resin stopper portion;
a support fixation step of fixing the support to the receiver substrate by bonding the support to the outer resin stopper portion and curing the adhesive resin;
a translucent resin injection step of injecting the translucent resin inside the inner resin stopper portion;
a columnar optical member placement step of placing the irradiation surface on the translucent resin with the columnar optical member abutted against the abutting frame member; and
a resin sealing portion formation step of curing the translucent resin to form a resin sealing portion.

12. A solar cell comprising: a solar cell element that photoelectrically converts sunlight concentrated by a concentrating lens; a receiver substrate on which the solar cell element is placed; and a resin sealing portion for sealing the solar cell element with resin,
wherein the solar cell further comprises a columnar optical member forming a light-guiding path for guiding the concentrated sunlight to the solar cell element, and
an optical holding portion that has a holding wall for holding the columnar optical member and that is placed on the receiver substrate so as to cover the resin sealing portion.

13. The solar cell according to claim 12,
wherein the columnar optical member has an inclined optical path surface that concentrates sunlight to the solar cell element, and the holding wall is configured as an inclined holding surface in conformity with the inclined optical path surface.

14. The solar cell according to claim 12 or 13,
wherein the optical holding portion is abutted against a metal base of the receiver substrate.

15. The solar cell according to any one of claims 12 to 14,
wherein the optical holding portion comprises a comb tooth-shaped fin on an outer peripheral side surface thereof.

16. The solar cell according to any one of claims 12 to 15,
wherein the columnar optical member is configured as a quadrangular prism, and the optical holding portion comprises groove-shaped notch portions respectively surrounding axial corner portions of the quadrangular prism.

17. The solar cell according to any one of claims 12 to 16,
wherein a thickness of the resin sealing portion is configured to be smaller between the columnar optical member and the solar cell element than in a surrounding region thereof.

18. A concentrating solar power generation module comprising: a concentrating lens that concentrates sunlight; and a solar cell that photoelectrically converts sunlight concentrated by the concentrating lens,
wherein the solar cell is the solar cell according to any one of claims 12 to 17.

19. A solar cell manufacturing method for manufacturing a solar cell comprising: a solar cell element that photoelectrically converts sunlight concentrated by a concentrating lens; a receiver substrate on which the solar cell element is placed; a resin sealing portion for sealing the solar cell element with resin; a columnar optical member forming a light-guiding path for guiding the concentrated sunlight to the solar cell element; and an optical holding portion that has a holding wall for holding the columnar optical member and that is placed on the receiver substrate so as to cover the resin sealing portion, the method comprising:
an optical holding portion preparation step of preparing the optical holding portion by forming metal;
an optical holding portion placement step of placing the optical holding portion so as to abut against the receiver substrate at the outer periphery of the solar cell element;
a resin injection step of injecting a sealing resin for forming the resin sealing portion into a space formed by the optical holding portion and the receiver substrate; and
an optical member placement step of placing the columnar optical member on the holding wall.
